# EUROPEAN PATENT SPECIFICATION

(11) **EP 1 040 358 B1**
(45) Date of publication and mention of the grant of the patent: **14.07.2004**
(21) Application number: 98950530.0
(22) Date of filing: 10.08.1998
(51) Int. Cl.: G01R 1/00

(54) **A MEMORY TEST SYSTEM WITH A MEANS FOR TEST SEQUENCE OPTIMISATION AND A METHOD OF ITS OPERATION**
SPEICHERPRÜFUNGSANORDNUNG MIT PRÜFSEQUENZOPTIMIERUNG
SYSTEME DE TEST DE MEMOIRES COMPRENANT UN DISPOSITIF D'OPTIMISATION DE LA SEQUENCE DE TEST ET PROCEDE D'OPERATION

(30) Priority: 09.08.1997 GB 9716812
(43) Date of publication of application: 04.10.2000
(73) Proprietor: Acuid Corporation Limited, Dalkeith, Edinburgh EH22 2NA (GB)
(72) Inventor: MUSTAFINA, Ekaterina Nikolaevna, St.Petersburg, 195269 (RU); DEAS, Alexander, Roger, Edinburgh EH22 1JW (GB)
(86) International application number: PCT/RU1998/000261
(87) International publication number: WO 1999/008116

(56) References cited:
- EP-A- 0 503 656
- US-A- 5 537 632
- "ALGORITHMIC PATTERN GENERATION AT THE TESTER" IBM TECHNICAL DISCLOSURE BULLETIN, vol. 32, no. 6A, 1 November 1989 (1989-11-01), pages 76-79, XP000043124 ISSN: 0018-8689

## Description

### Technical Field

The present invention relates to test equipment for testing memory devices with means to optimise features of the test according to the test results generated by the equipment at an individual defect level.

The present invention is particularly applicable to test equipment for testing semiconductor memories at a wafer probe stage or as packaged parts.

In the semiconductor industry, devices are fabricated on silicon wafers, typically from 4 to 8 inches in diameter, with typically 400 die per wafer. These are tested using automated test equipment (ATE) driving the die and measuring the response. After test, the wafer is sawn and the good die are packaged, burnt in and retested.

Test time, coverage and profile are significant competitive factors for the memory manufacturer, who will therefore seek to reduce test times, increase coverage and profile the tests to achieve maximal early abort.

When a new memory design is created, a set of engineering tests is executed to characterise the new device. Once this has been done, a set of production tests is issued: these are typically between 50% and 95% shorter than the engineering tests. This reduction is achieved by analysing the number of failures from each test, and creating a bin profile (memories failing particular tests or with a particular range of defects are sorted into bins). Once the device is in production, further test time reductions and profile improvements are made: this again uses the bin data.

Analysis of test results using bin data, that is knowledge only of the number of defects found by each test, requires great care. It is necessary for an operator to monitor the growth of the defect count during a test run, then to reorder the tests to determine how many new defects each test is finding.

According to "Algorithmic pattern generation at the tester", (IBM technical disclosure bulletin, vol. 32, no.6A, November 1989, p.p.76-79) a memory test system comprises a tester, a means for obtaining data on defects discovered during the test, and a means for modifying the test sequence according to optimised data. However, the optimisation means and criterion are not described in detail. It should be understood that for example, in a typical sequence of 70 tests, simply to calculate the uniqueness of each test in this manner requires 70², or 4900, test runs even given optimistic assumptions about the device behaviour. Moreover, as the process changes, the optimisation must be repeated.

A test pattern device and method of operation of a test sequence optimisation means including obtaining data on defects discovered by a plurality of tests in a sequence and modifying the sequence using the information on the logic states of the circuits to reduce the test time are described in EP-A-0503656.

Known is a method of testing electronic circuits (see US 4728883) by applying a sequence of test vectors to a memory device under treatment, wherein if a part of a preceding serial scan vector indicates the presence of a defect, the corresponding part of a succeeding serial scan vector is prevented from indicating the presence of a defect. Thus, test time is reduced by avoiding excess information. However, the known method does not provide optimisation of the obtained sequence.

A method of testing semiconductor wafers is described in US 4875002. According to this method, testing time is improved by varying the sequence of tests on each chip in such a way that the test which has the highest probability of detecting a defect is performed first so that the number of testing steps can be reduced. However, the known method is based on the assumption that wafers in one lot and neighbouring chips on one wafer are similar in characteristics which is not likely and may cause erroneous results. According to the known method, chips or wafers having defects are rejected without analysing fault bit maps, therefore the performance of each test at an individual cell level is unknown.

The advantage of the present invention is the ability of an ATE system to optimise automatically its own test sequences using fault bit map data to generate information allowing test pattern sequence optimisation to maximise the coverage as a function of time. Though it may seem that analysing full bitmaps is a time-consuming operation, which can even increase test time, the final test efficiency is improved and the total test time is reduced when using the proposed means for test sequence optimisation exploiting the heuristic criteria explained in detail below.

It is an object of the present invention to provide a means for an ATE system to optimise its test patterns and to present information on both the patterns and the devices under test (DUTs) which has hitherto required multiple test runs and considerable manual intervention and interpretation.

The aforementioned object is achieved by a memory test system as claimed in claim 1 and by a method of operating a test sequence optimisation means as claimed in claim 8.

The substance of the invention is a means to create a new fault bitmap of the DUTs after each test, test segment or test group, and correlate automatically changes or differences in those bitmaps, and a means to inform the equipment operator of the improvement for either manual or automatic incorporation into ATE control, pattern or timing systems.

Thus, the invention is a combination of both hardware and software in a system to execute each test in a sequence and for each test, test segment or test group, to obtain by hardware means fault bit maps for each test, preferably to compress the said bitmaps, to accumulate the bitmap fail data during the test and correlate each bitmap using analysis hardware or software to determine the performance of each test at an individual cell level, where the cell is the smallest addressable unit stored in the bitmap, preferably one binary bit, but with DUTs in a special test mode the cell size may be larger than one bit, or the cell may represent a logical operation on all data (DQ) planes of the DUT at a particular address or address window.

According to the invention, defect groups are analysed using test vectors that can be stored in a system due to system capability for storing fault bit maps for each test in a sequence. Thus, the test vector is a test pattern sequence subset that finds at least one defective cell in a memory device lot under test.

For a better understanding of the present invention and to show how the same may be carried into effect, reference will now be made, by way of example, without loss of generality, to the accompanying drawings in which:
Fig.1 is a block diagram of the current invention showing a DUT 1 being tested by an ATE system 2 with a fault bit map capability in the form of an error catch RAM 3, a bit map compressor 4 and a correlation means 5, with a sequence optimisation means 6 connection 713 to a computer 8 for storing or displaying information from the correlation. Any function may migrate between hardware in the ATE system and in the computer.
Fig.2 shows a flow chart of operation of the sequence optimisation means for performing a correlation of test results from the bit maps.

The invention will now be described, without loss of generality, with the aid of an example embodiment.

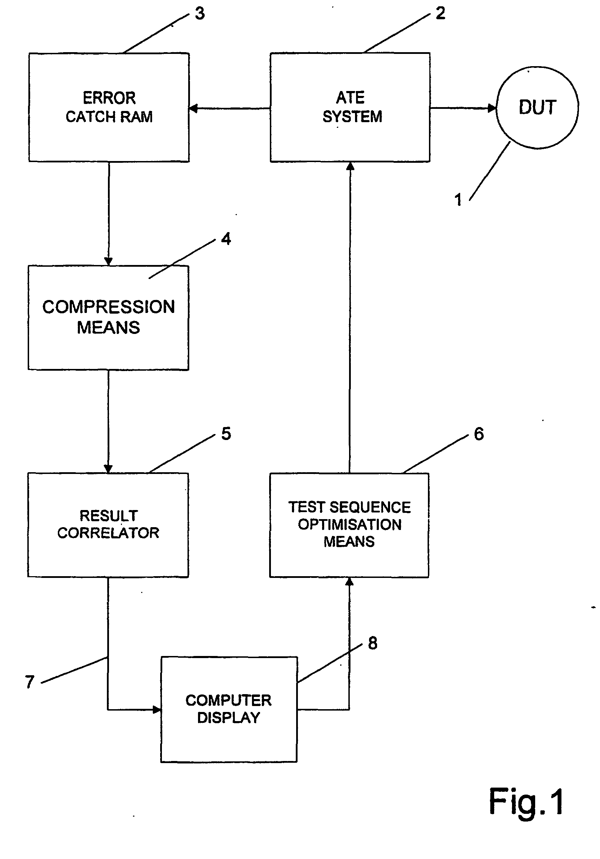

In Fig.1 the memory test system 2 is configured to execute each test in a sequence and for each test or test segment or test group, to obtain by an error catch RAM 3 fault bit maps for each test. In the error catch RAM a FIFO is emulated using an SRAM to store the fault address, the data bit with the fault and other parameters (cf. annex).

As faults are detected, or after each test pattern is run, the fault store is downloaded into a correlation means, which correlates the fault addresses so as to identify the particular set of tests which found each fault in a cell. Another basic function of the correlation means is to accumulate the bitmap fail data during the test and correlate each bitmap using analysis hardware or software to determine the performance of each test or test segment or test group at an individual cell level, where the cell is the smallest addressable unit stored in the bitmap.

A correlation means may be implemented as an ASIC or as a software program running on a computer to which the individual fault maps are downloaded. The computer or ASIC will preferably hold the accumulated data in a compressed format, for example by storing two of the corners of the region sharing the same pattern of defective cells, with a second level of compression formed by block encoding this data.

In this example embodiment the cell size may be one memory bit, or may be a plurality of bits but less than one thousandth of the total number of storage bits in the DUT.

Under some test conditions the DUT performs a logical operation on all data (DQ) planes of the DUT where there is either a fault or the contents of the planes are different within a certain address window. The present invention can perform the analysis on this permuted data as an alternative to using the real 1s and 0s data.

After the correlation of the accumulated data, the tests or the test performance can be optimised automatically to reduce the test time by modifying or causing to be modified the test pattern sequence of the memory tester.

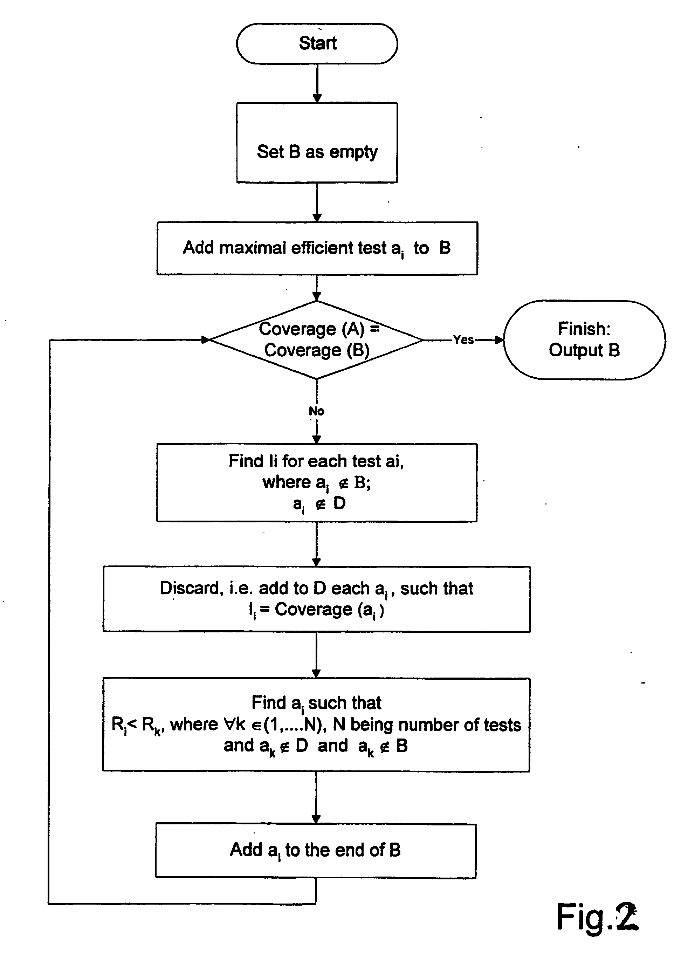

Fig. 2 forms an example embodiment of an automatic test pattern optimisaton means which minimises the overlap (redundancy), the total test time and the ramp of test coverage. The result of the optimisation is to modify the test pattern sequence of the memory tester, or to dump results that cause it to be modified.

An extension of this example embodiment is to connect the correlated data to an automated analysis tool to determine the cause of faults identified by particular tests at a geometric, type, process or electrical level.

Alternatives to use of the FIFO to provide the error catch ram is a memory test system, any other register or content addressable store or FILO or RAM containing a list of address fail data and the data bit and DUT with the failure.

The correlation function may be applied with data from a plurality of memory test systems connected directly or indirectly such that the said performance data or individual cell fail maps are applied with a cross-correlating function for the purpose of identifying differences in the performance of test systems, or of different tests or of different test conditions or of different timing sets.

The problem of minimising the redundancy in test coverage to optimise a test sequence is described below:

### Input

n - number of tests performed on chips in the database;
A = ( a₁, a₂ ... , aₙ) - represents sequence of tests performed, A - ordered array;
T = ( t₁, t₂, ... , tₙ ) - represents array of test durations, i.e. tᵢ presents the duration of test aᵢ
**T**_{**A**} - total test sequence A time of execution = Σ t_{i;}
Coverage (A) - is a set defects found by sequence A, i.e. found by at least one test from the sequence.

### Output

B = ( b₁, b₂ ... , bₘ ) - optimized sequence of tests performed, transposition of subset A with the following property: Coverage(A) = Coverage(B), **T**_{**A**} <= **T**_{**B**} (i.e. m <= n), B being empty if B contains no tests.

The problem as described above can be proven to be in the class of NP-complete problems, so finding the optimal solution will take exponential time; therefore the practical embodiments of procedures to solve this problem would apply a heuristic to find a near optimal solution.

The example embodiment in Fig.2 applies the following method, where S is a subsequence of A and **I( S, a**_{**i**} **)** is the Coverage ( S) ∩ Coverage (aᵢ ), aᵢ - test i.

The embodiment also introduces **R** as the redundancy coefficient, where **R = I/t**_{**a**} is a coefficient representing how much redundant work is done per unit of time.

The procedure minimises total test time by choosing the next test to be the one with the minimal redundancy coefficient **R**. The procedure selects the first test to include in the final optimized sequence B, then adds one test on each iteration with the minimal redundancy coefficient. A Branch and bounds algorithm is used.

In pseudo-code, this solution is:
Additional Data structures:
   D - array of discarded tests D(i) ∈ { 0, 1} ;
   I = ( I₁, I₂, ... , Iₙ ) intersections array Iᵢ present I (B, aᵢ )
   Rₘᵢₙ - minimal Rᵢ
      1. B = ( ); set final sequence B to the empty state.
      2. Find test i with max efficiency i.e. Coverage (aᵢ - ) /. Add aᵢ to the end of B.

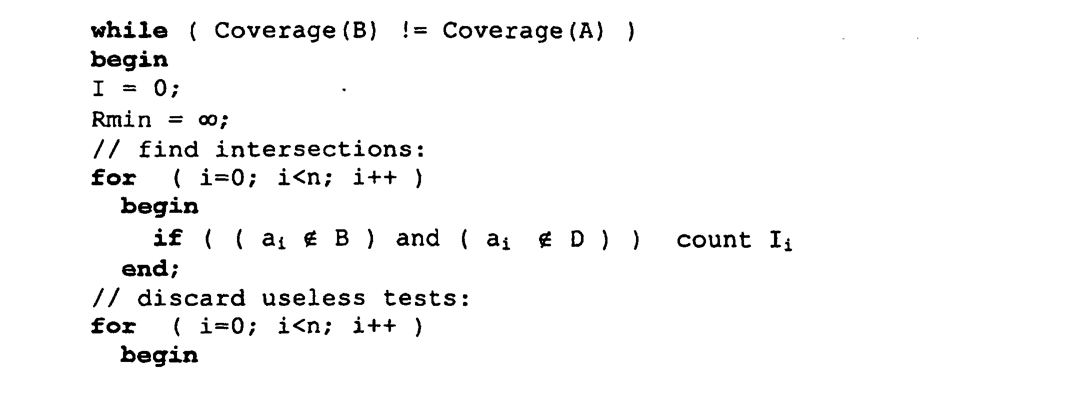

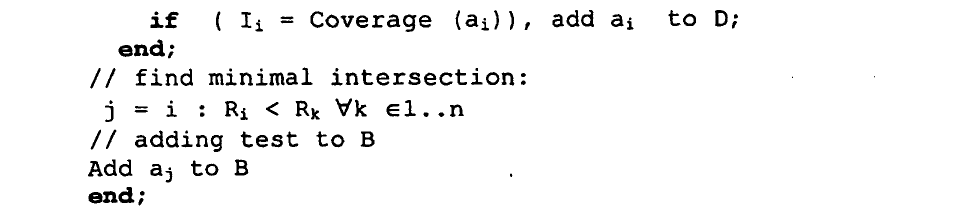

According to the invention, the proposed procedure may be modified as follows, where S is a subsequence of A and D **(S, a**_{**i**}**)** is the Coverage (S) \Coverage (aᵢ ), aᵢ - test i, **M** is the max coverage coefficient and **M = D/t**_{**a**} is the coefficient representing how much useful work is done per unit of time.

The procedure seeks to maximise coverage at each step of constructing a test sequence with the shortest test time (i.e. take next test with max coverage coefficient **D**). The procedure selects the first test to include in the final optimized sequence B, then adds one test per iteration with the maximum coverage coefficient. Again a Branch and bounds algorithm is used in the example embodiment.

Still another modification of the proposed method includes the following steps for obtaining an optimal test sequence :
- creating reduced durations by dividing each test durationby the number of defect groups, which will be covered by each additional test);
- sorting vectors in groups with the same bit amount to cover initially vectors which contain fewer tests and then vectors with a greater number of tests;
- scanning through the vector list (scan through list only once and building a result vector);
- checking superfluity and removing the longest useless tests (heuristic of the algorithm does not allow redundancy to be avoided completely; to decrease redundancy, check if any tests can be removed from result and remove test with the longest time);
- copying results to a parameter "vector" (build special array, where every cell contains either 0 if test has not been included, or percentage of defects covered after including this test and all previous tests).

The branch and bounds method is used in the example embodiment.

It will be appreciated that the above description and the figures are an example embodiment only and that various modifications may be made to the embodiment described above within the scope of the present invention.

### Annex:

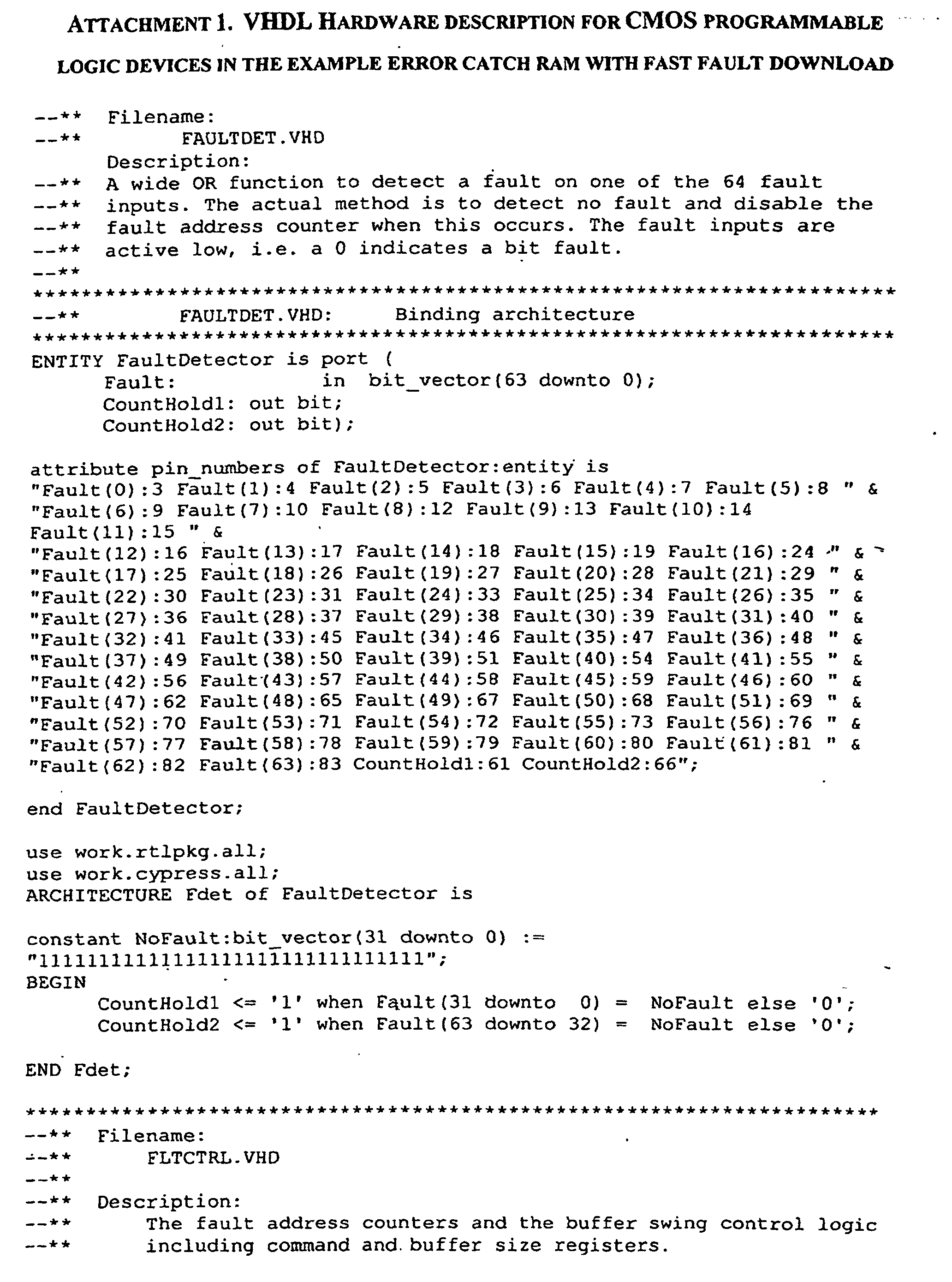

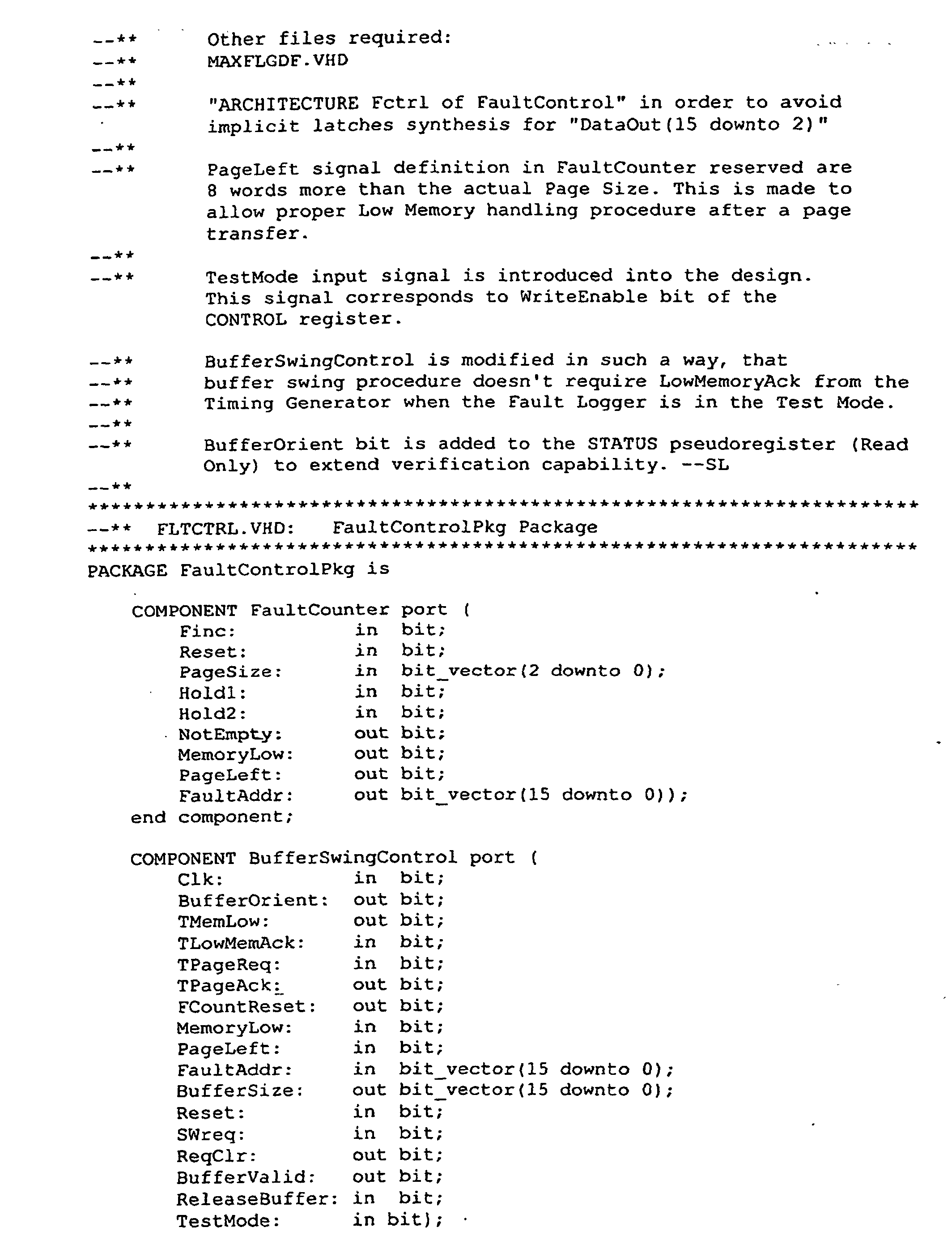

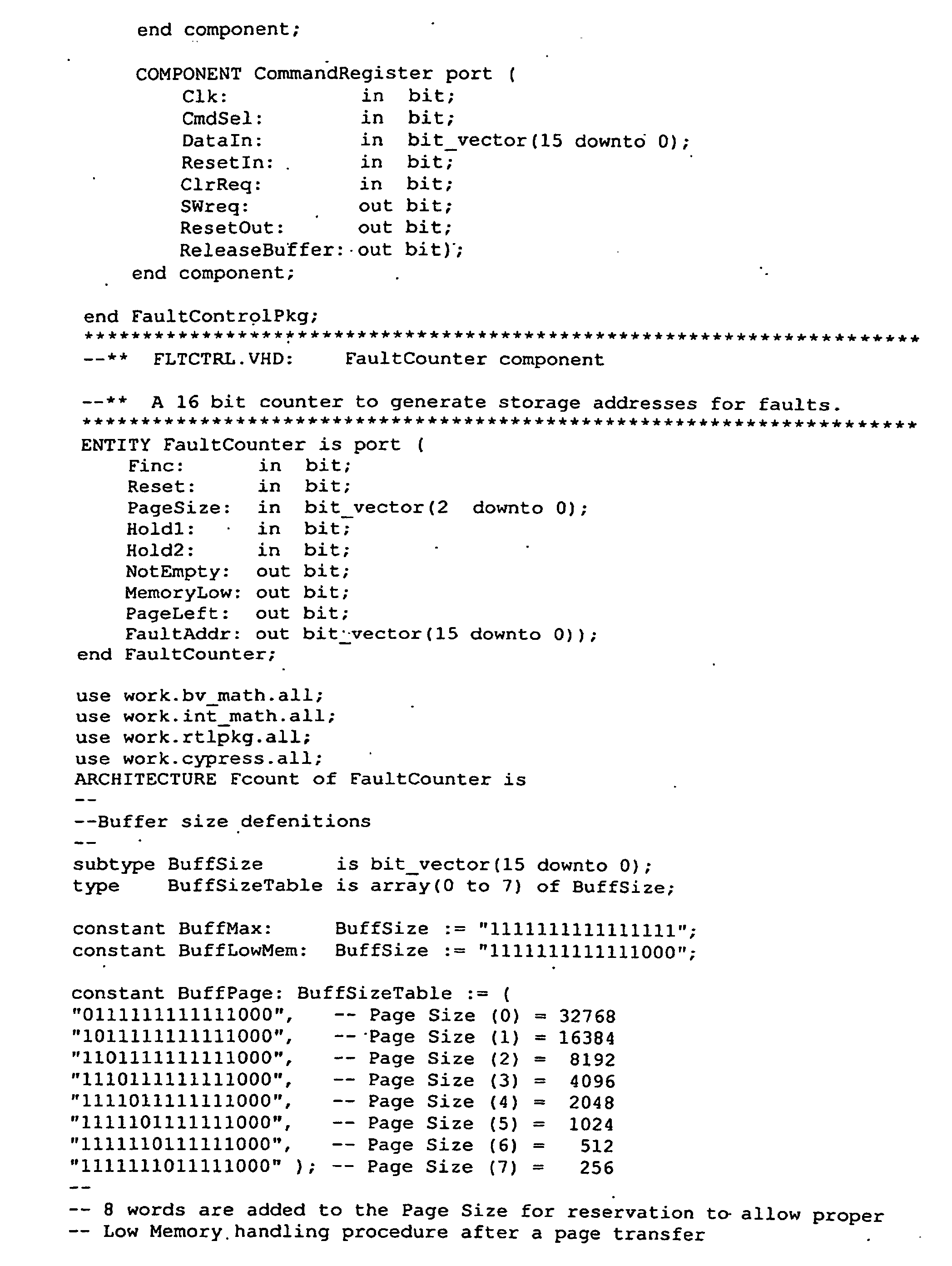

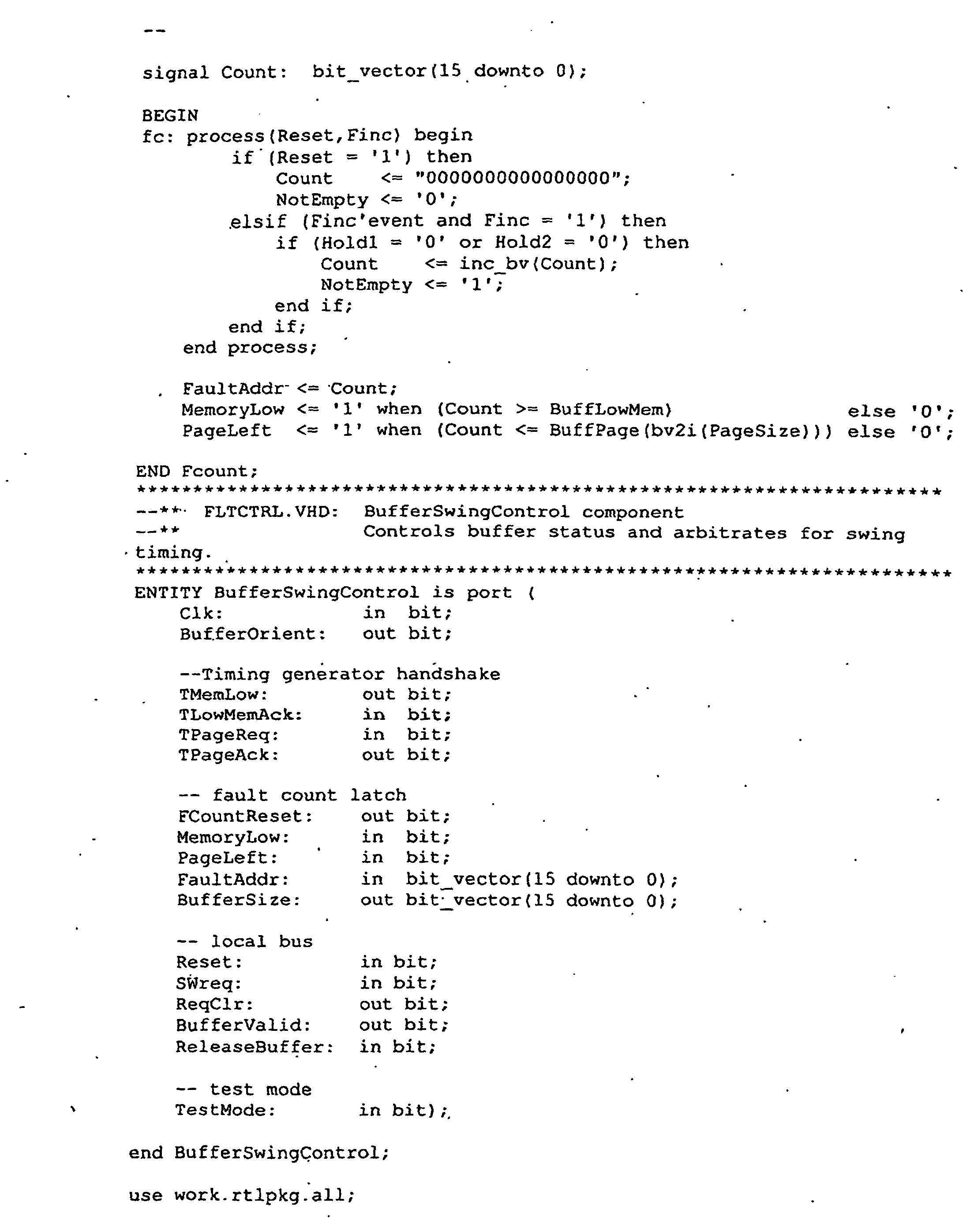

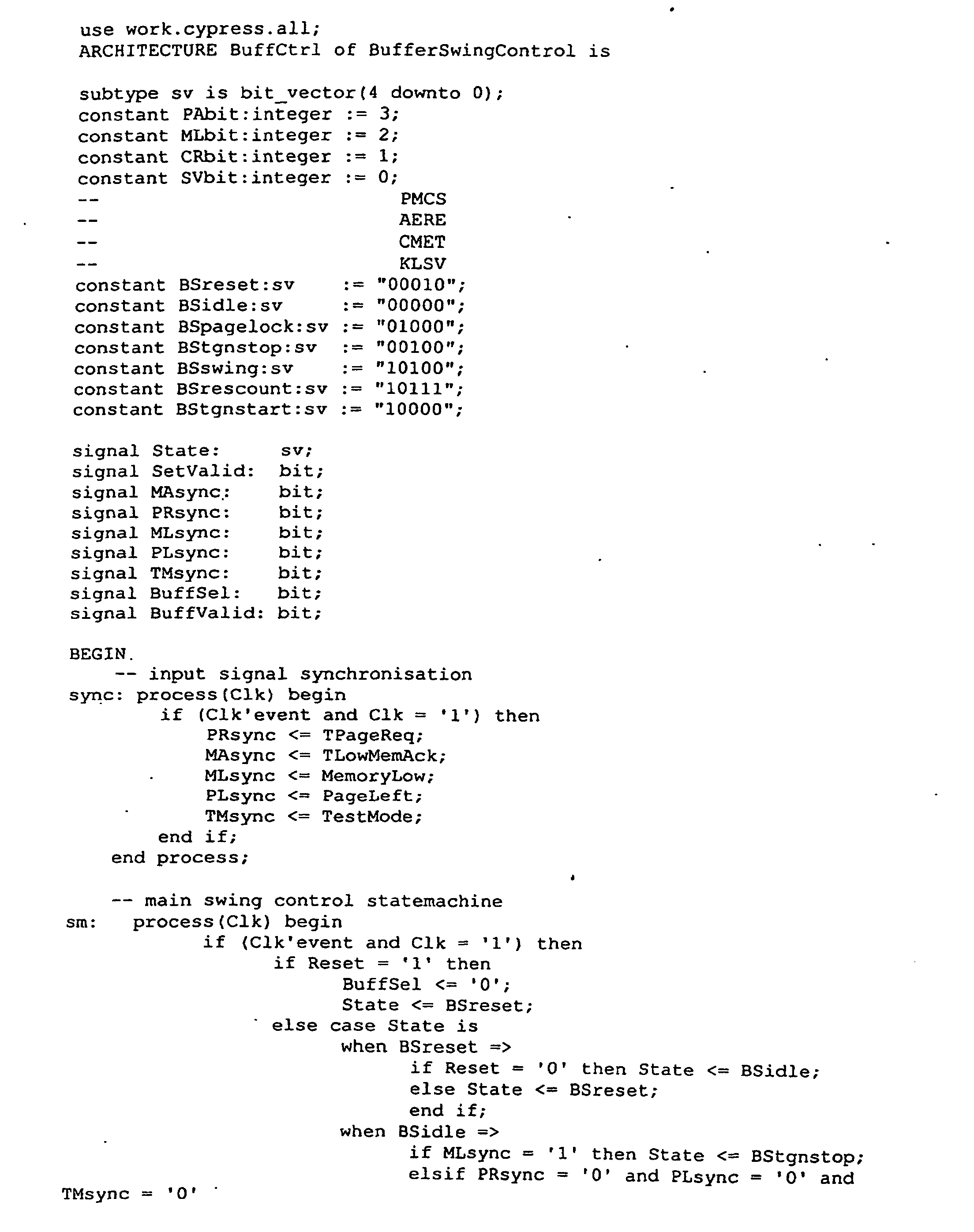

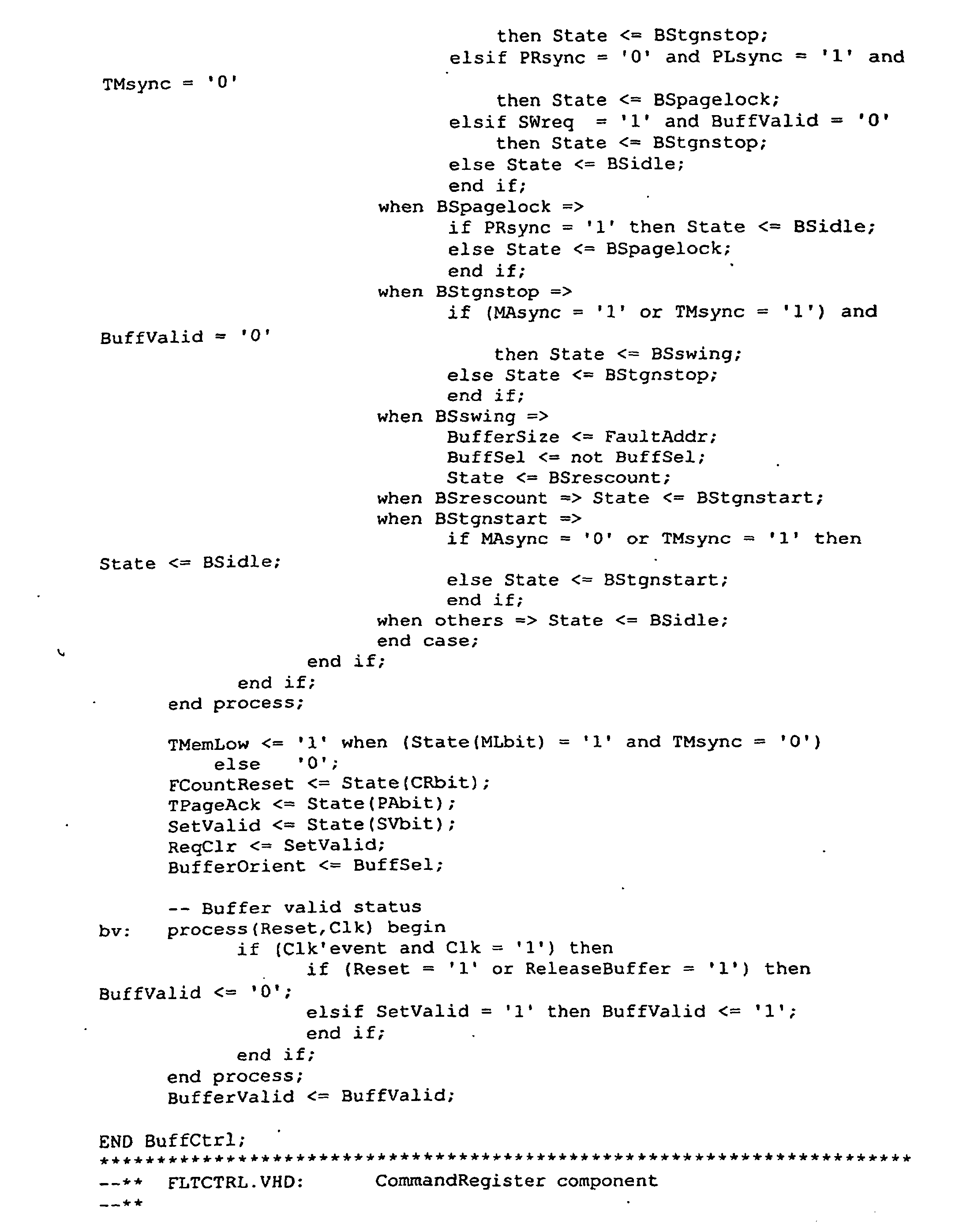

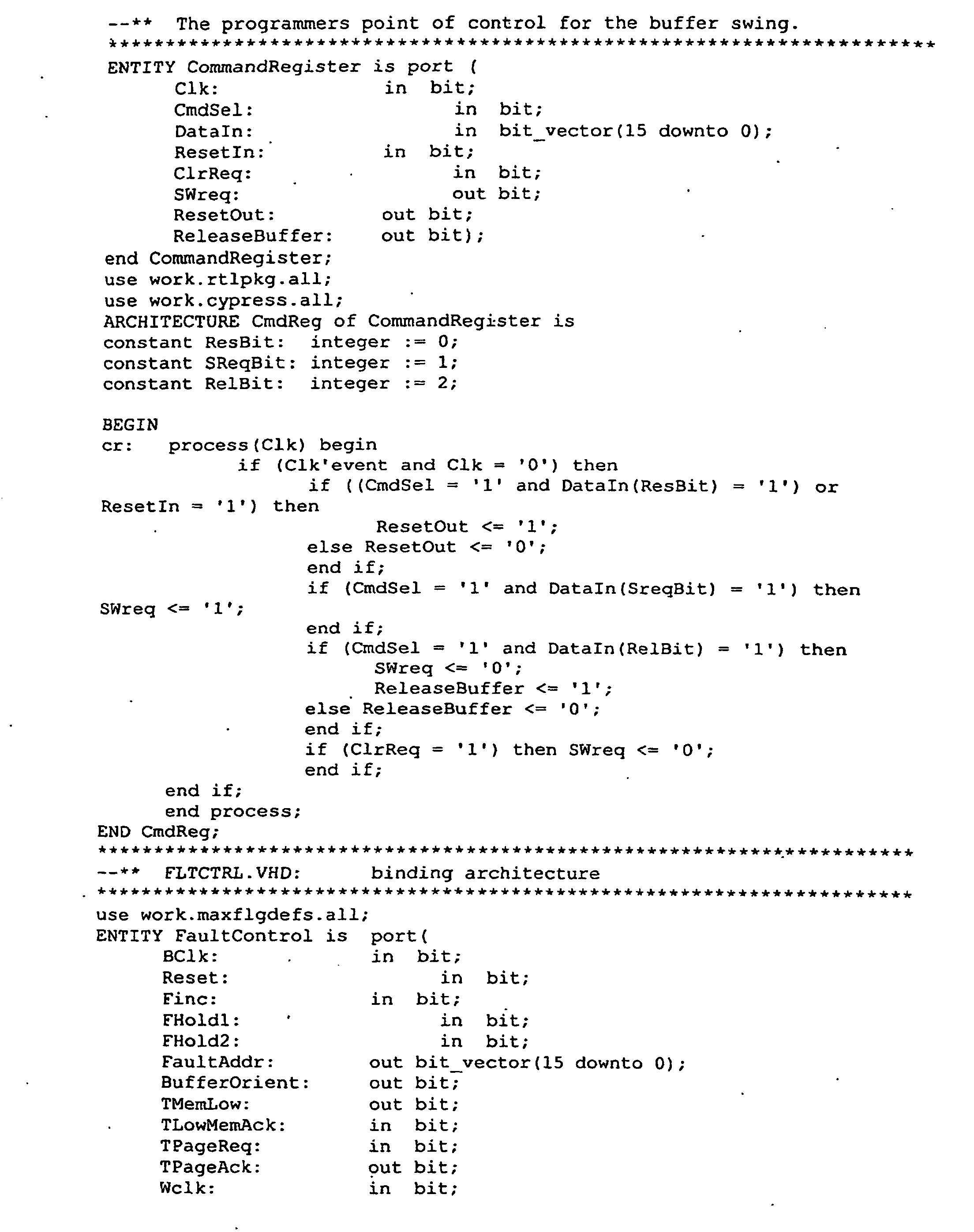

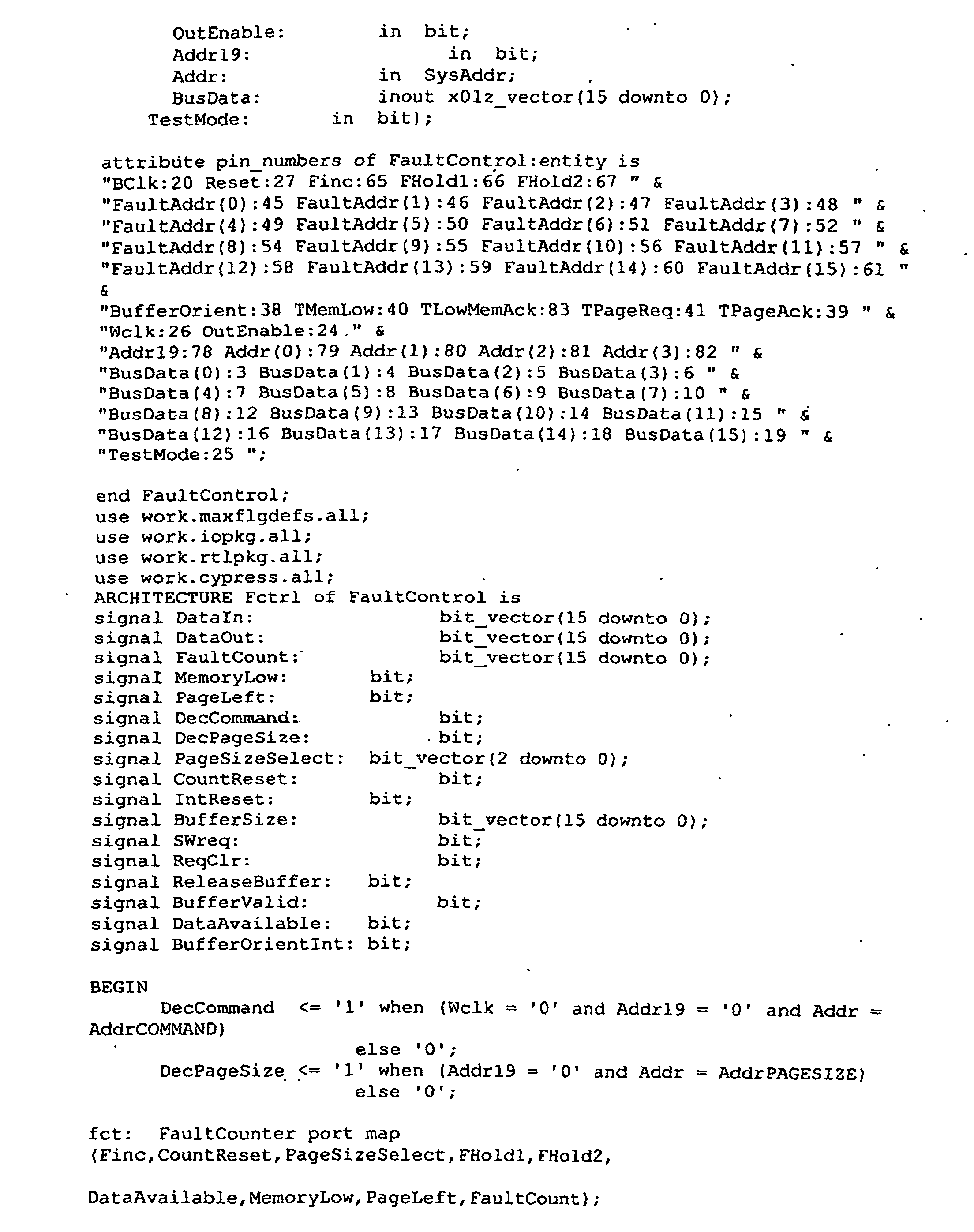

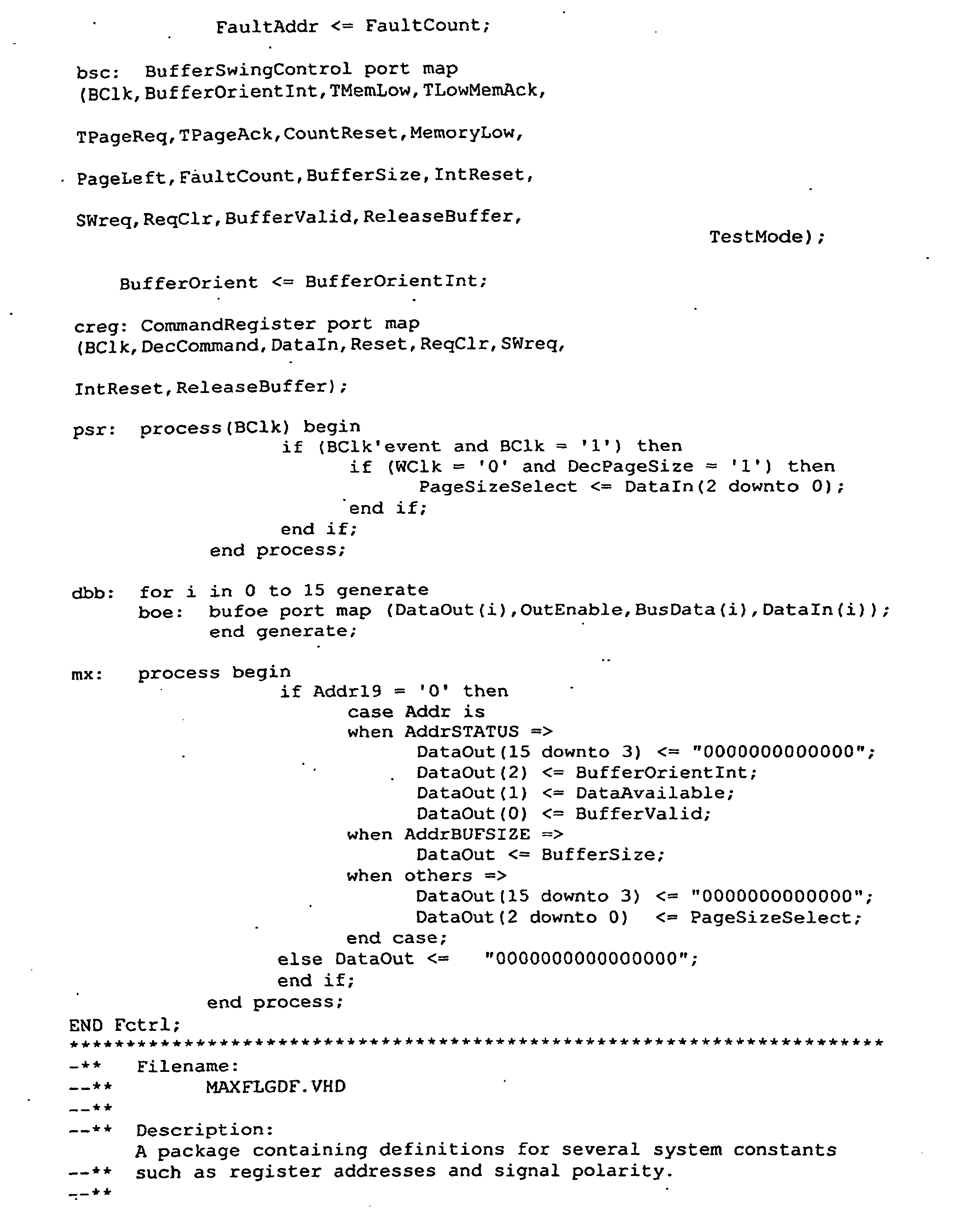

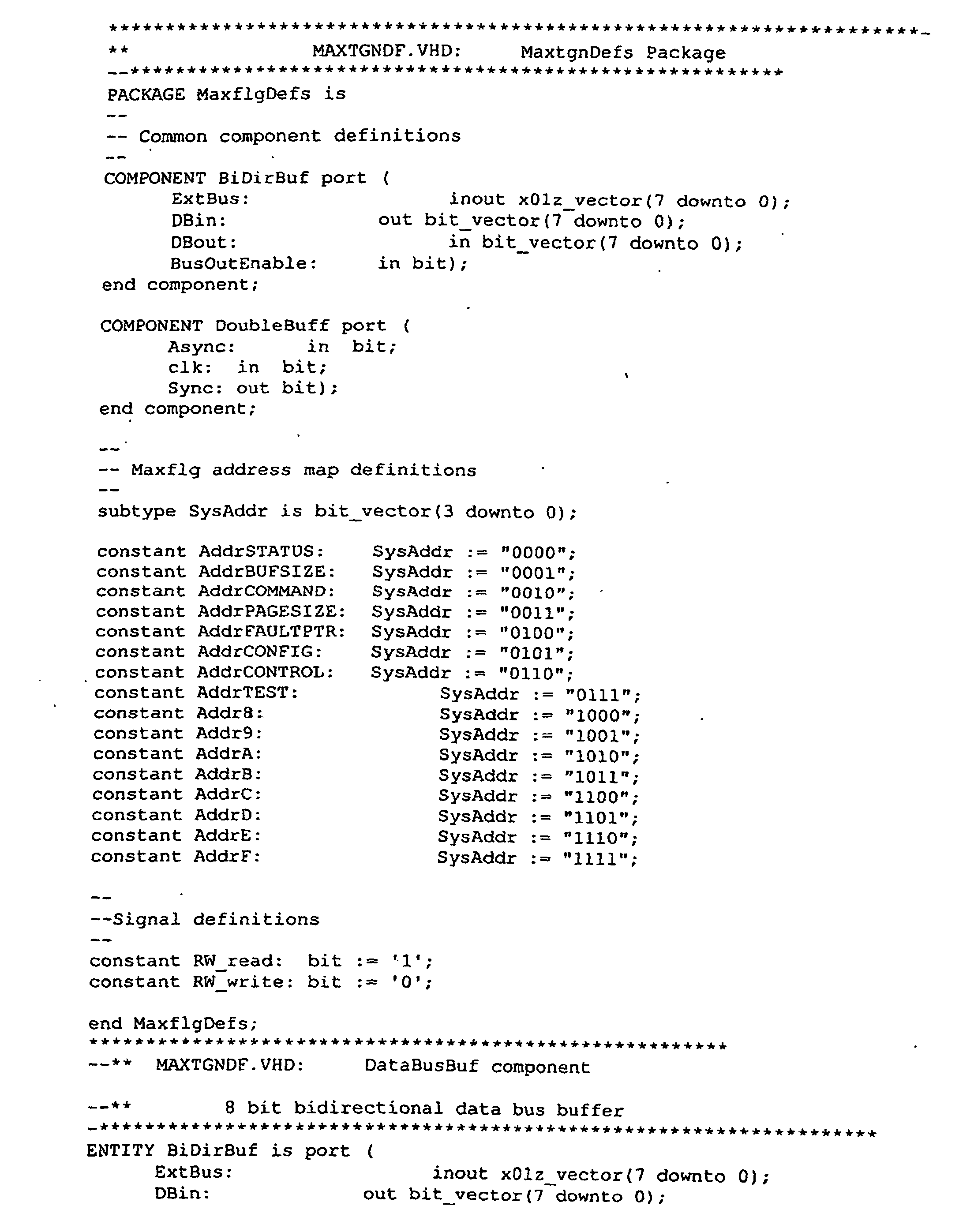

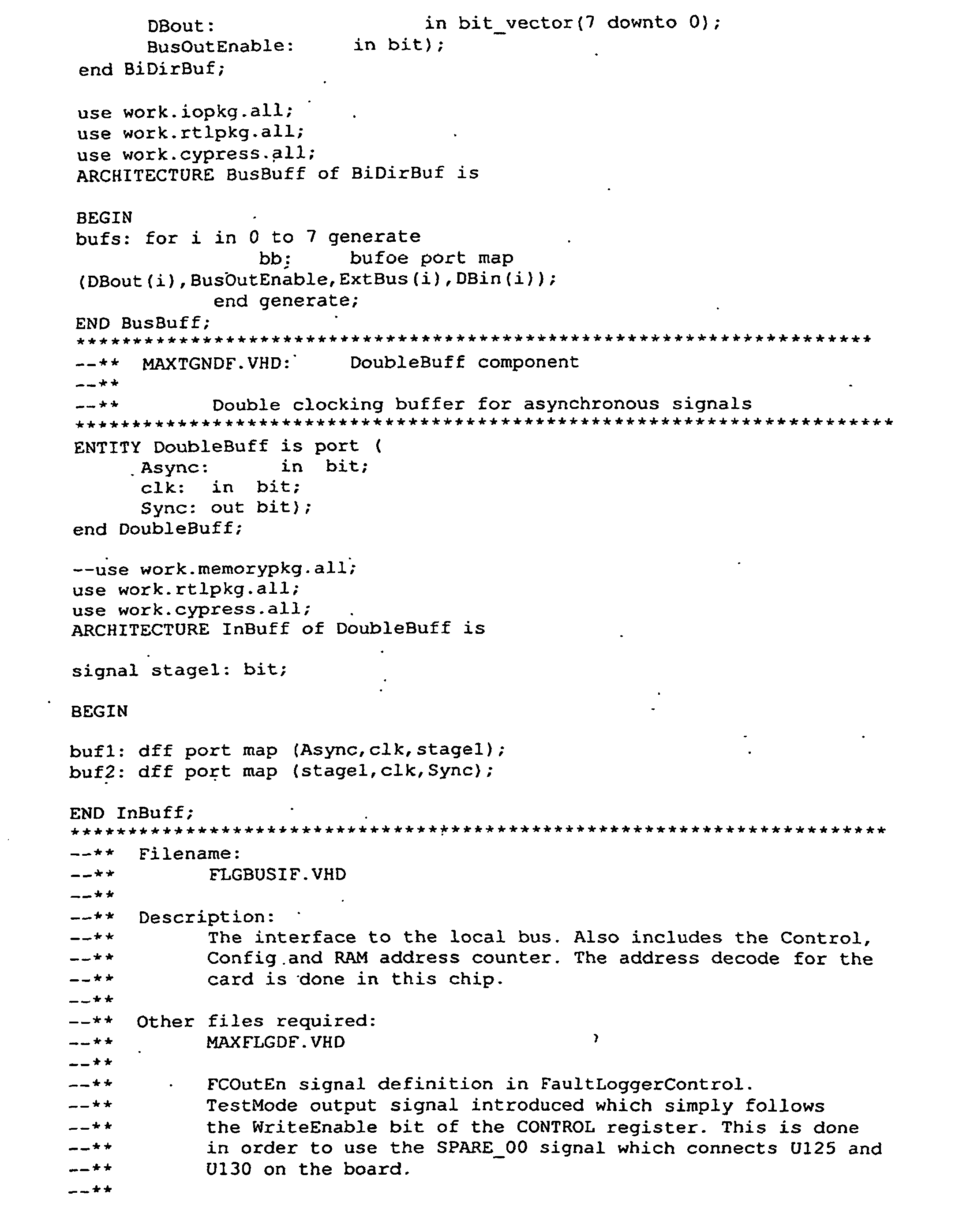

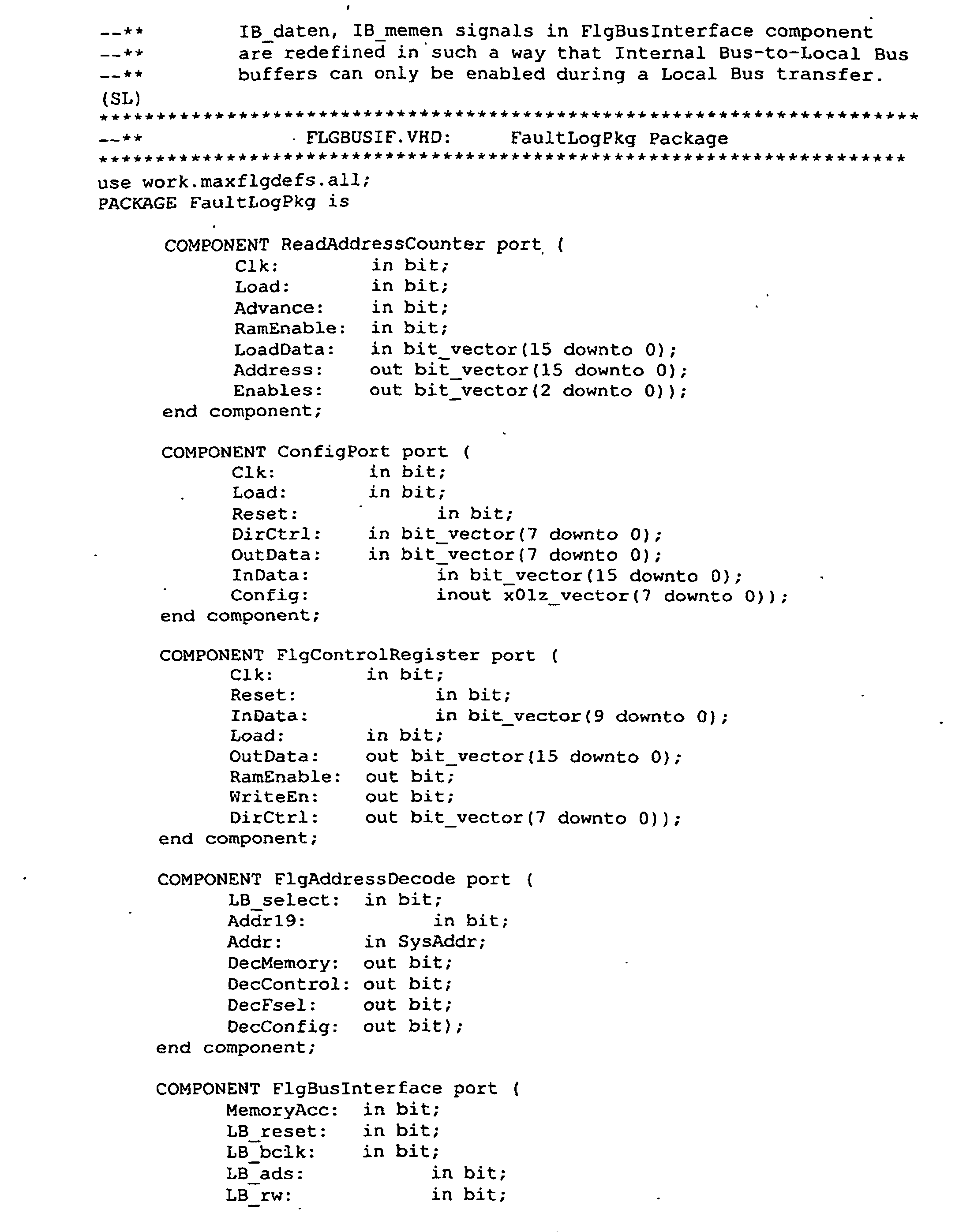

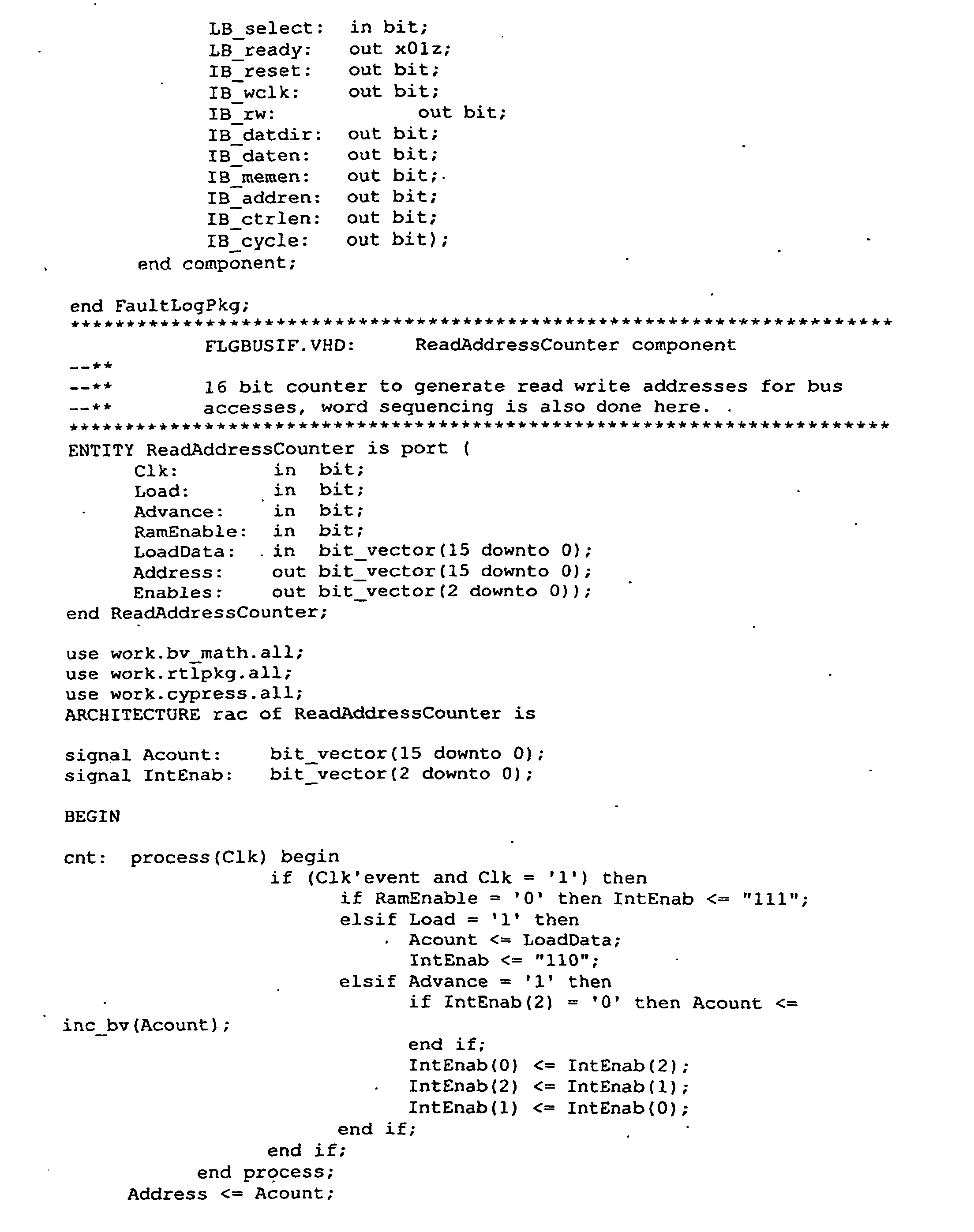

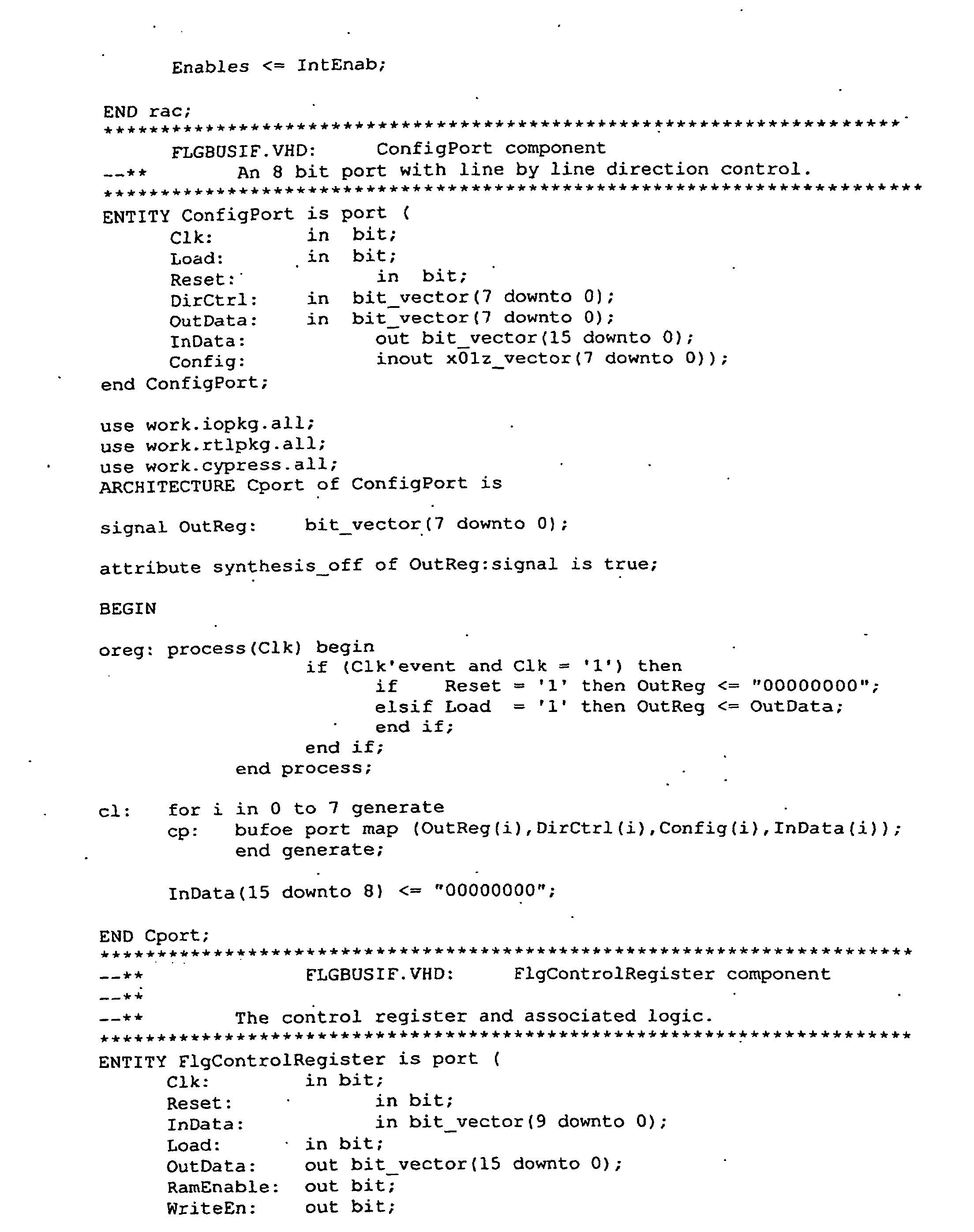

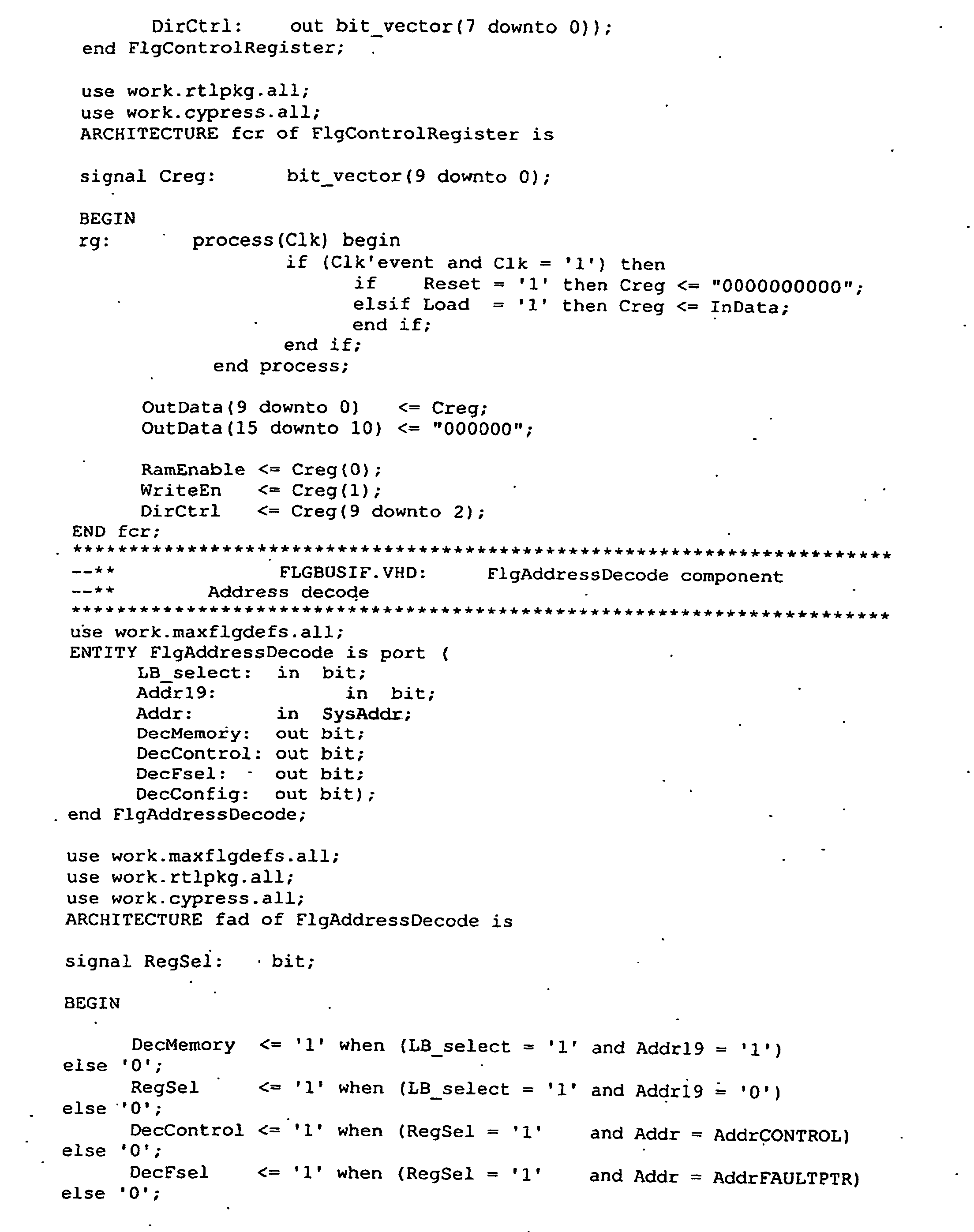

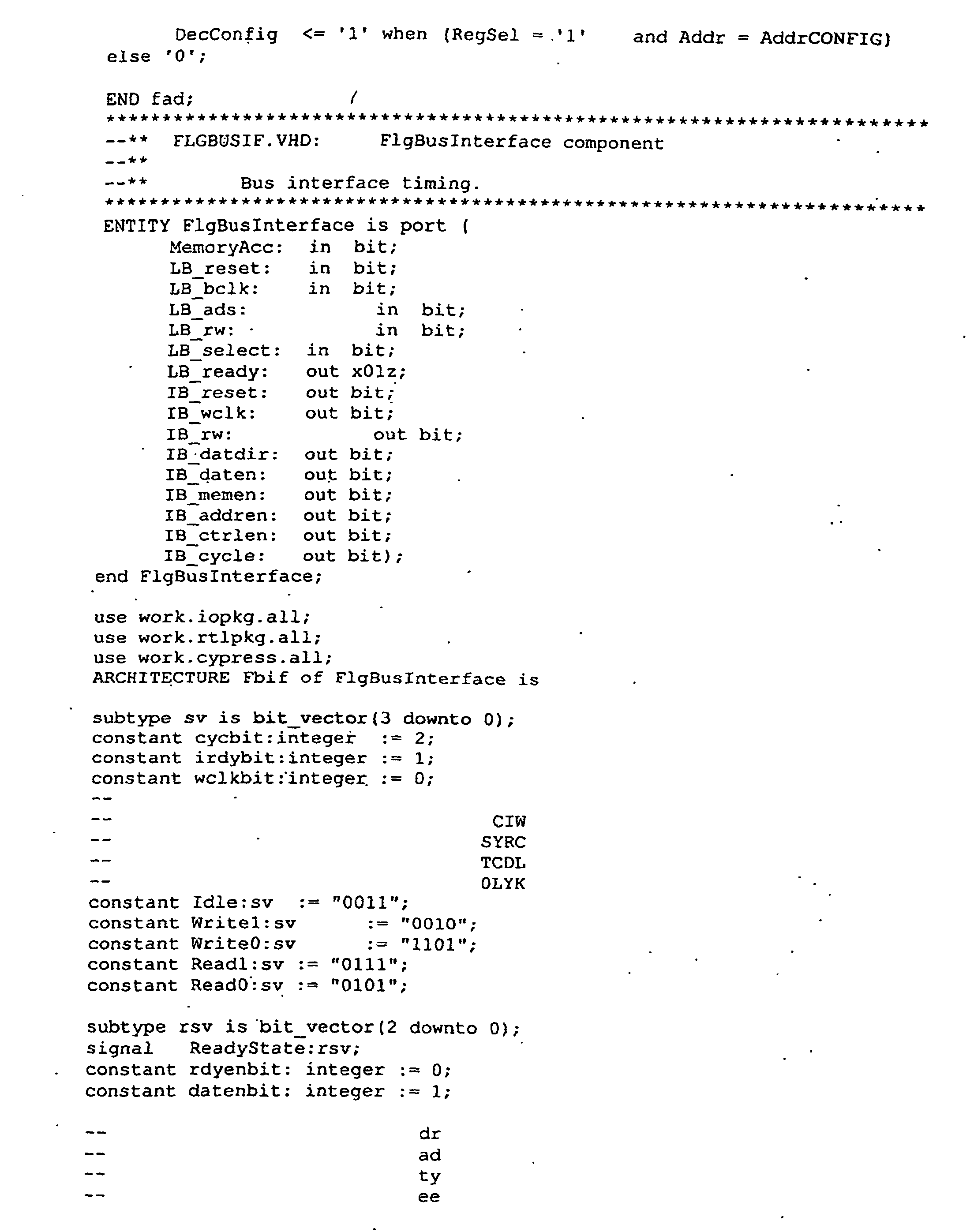

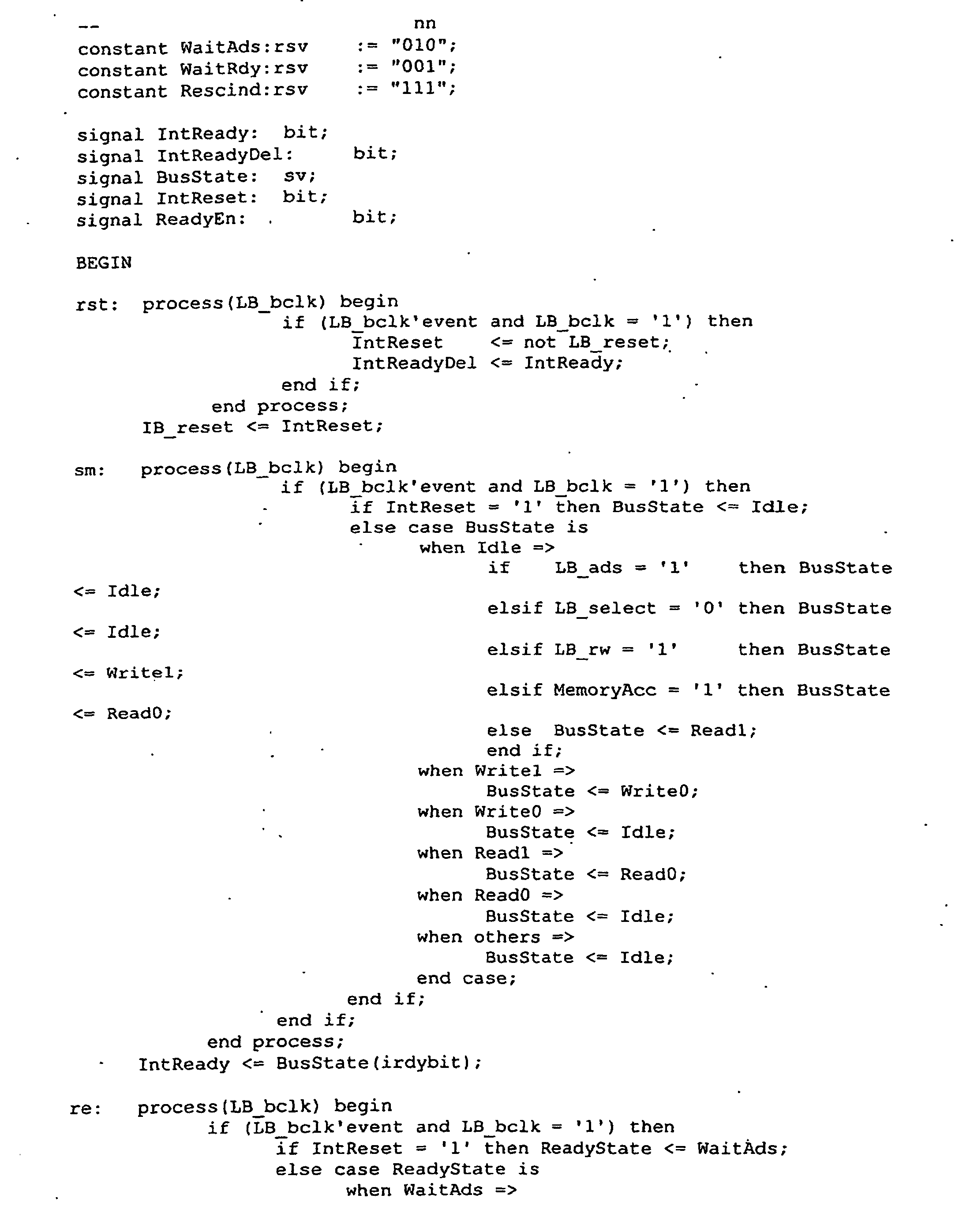

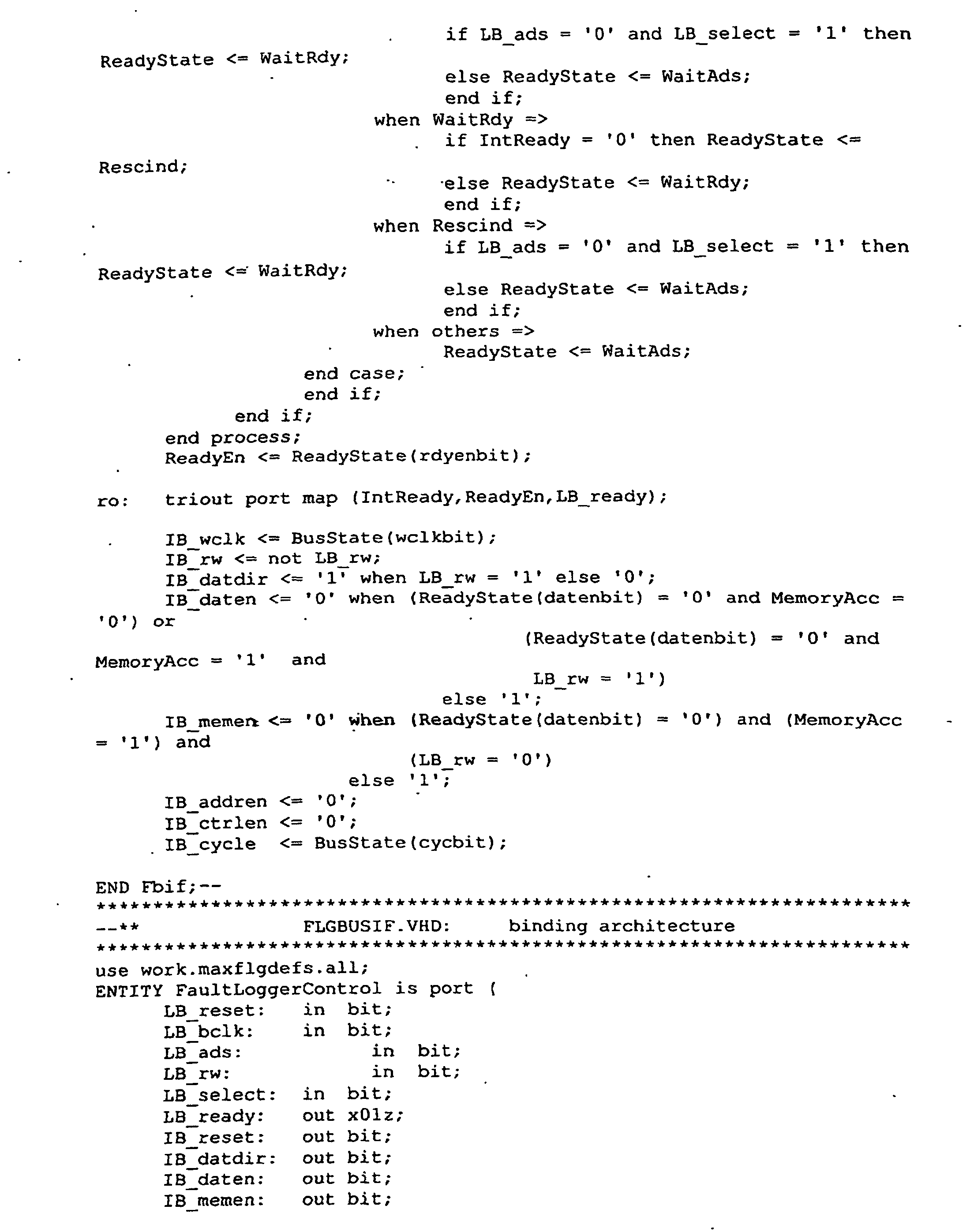

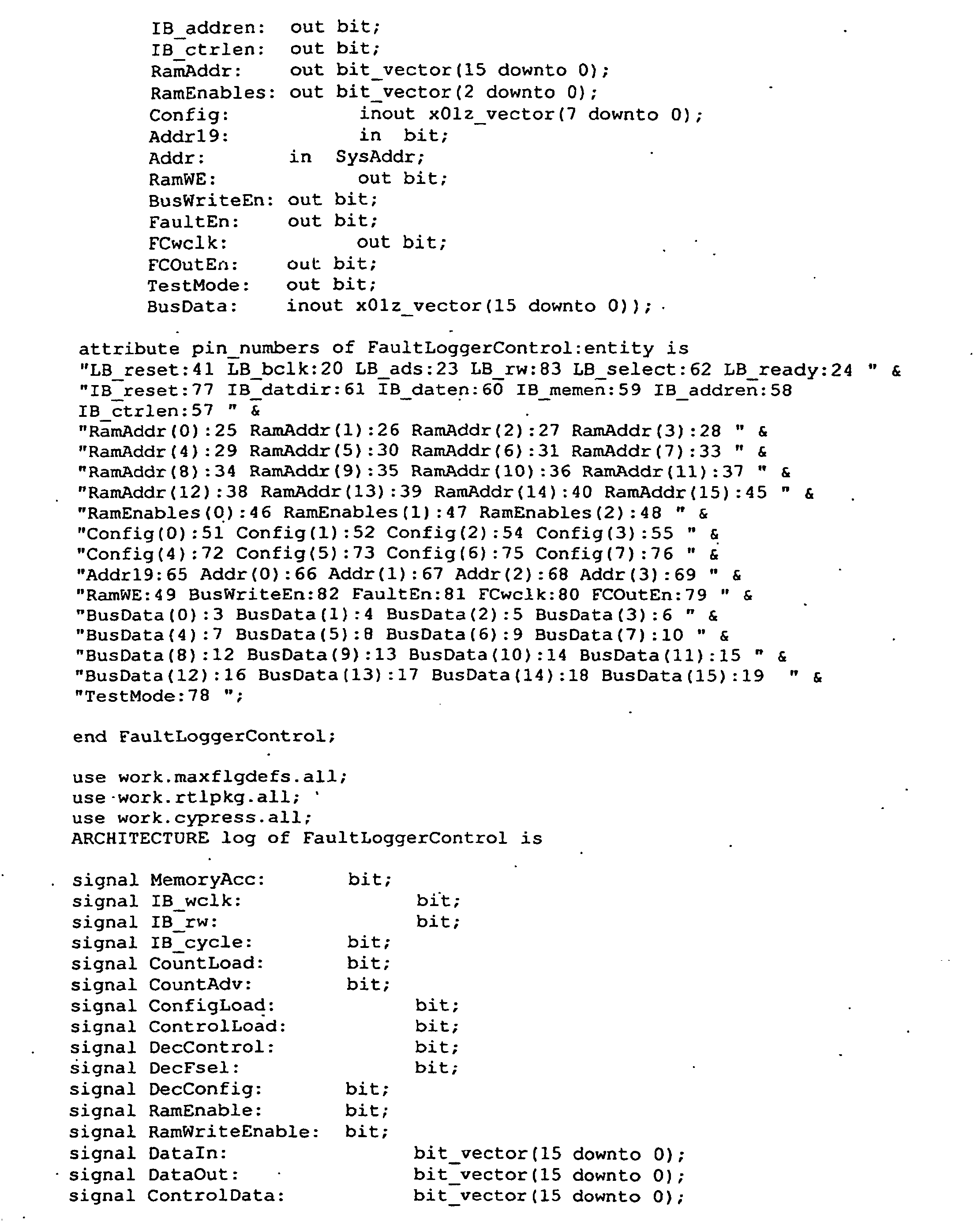

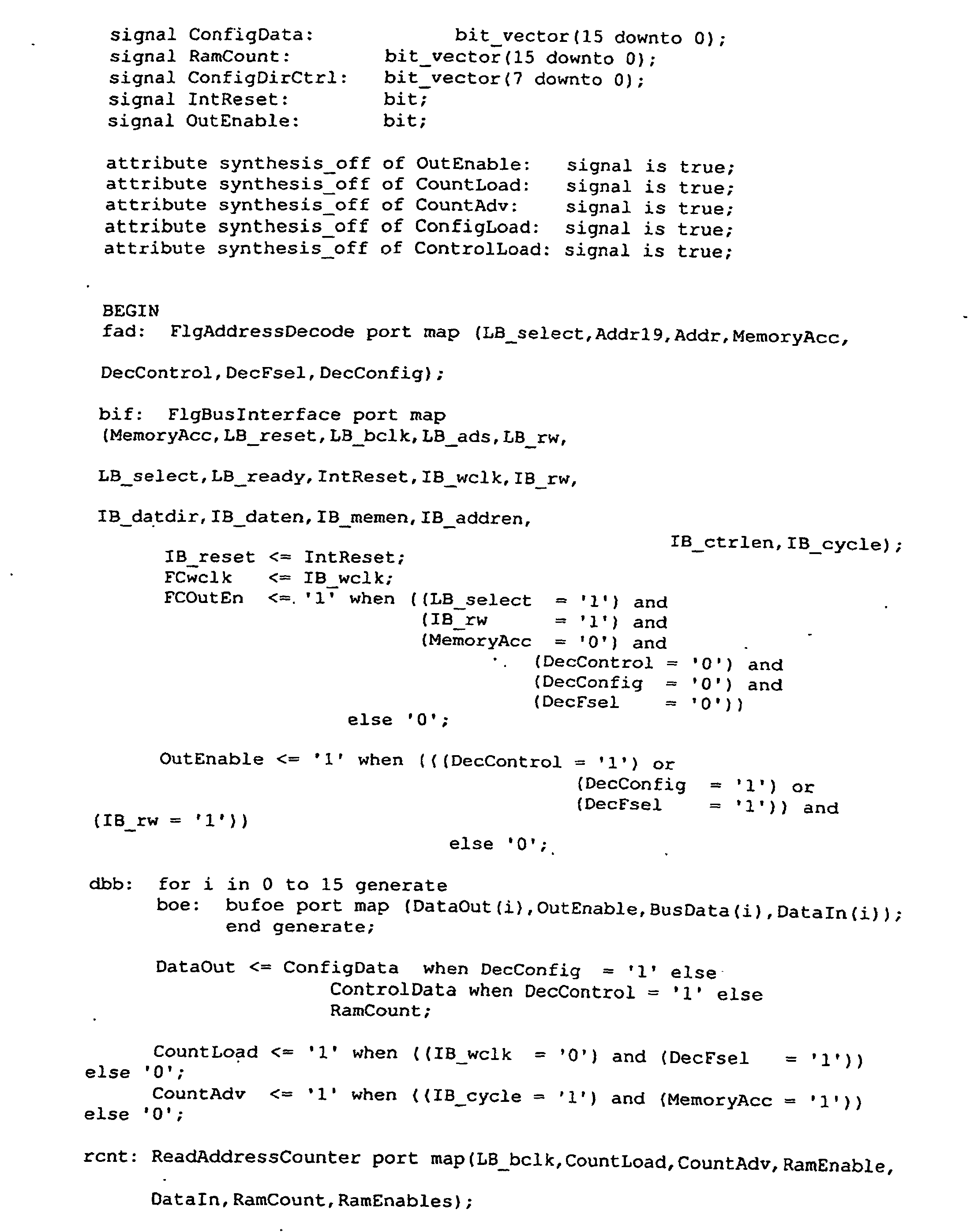

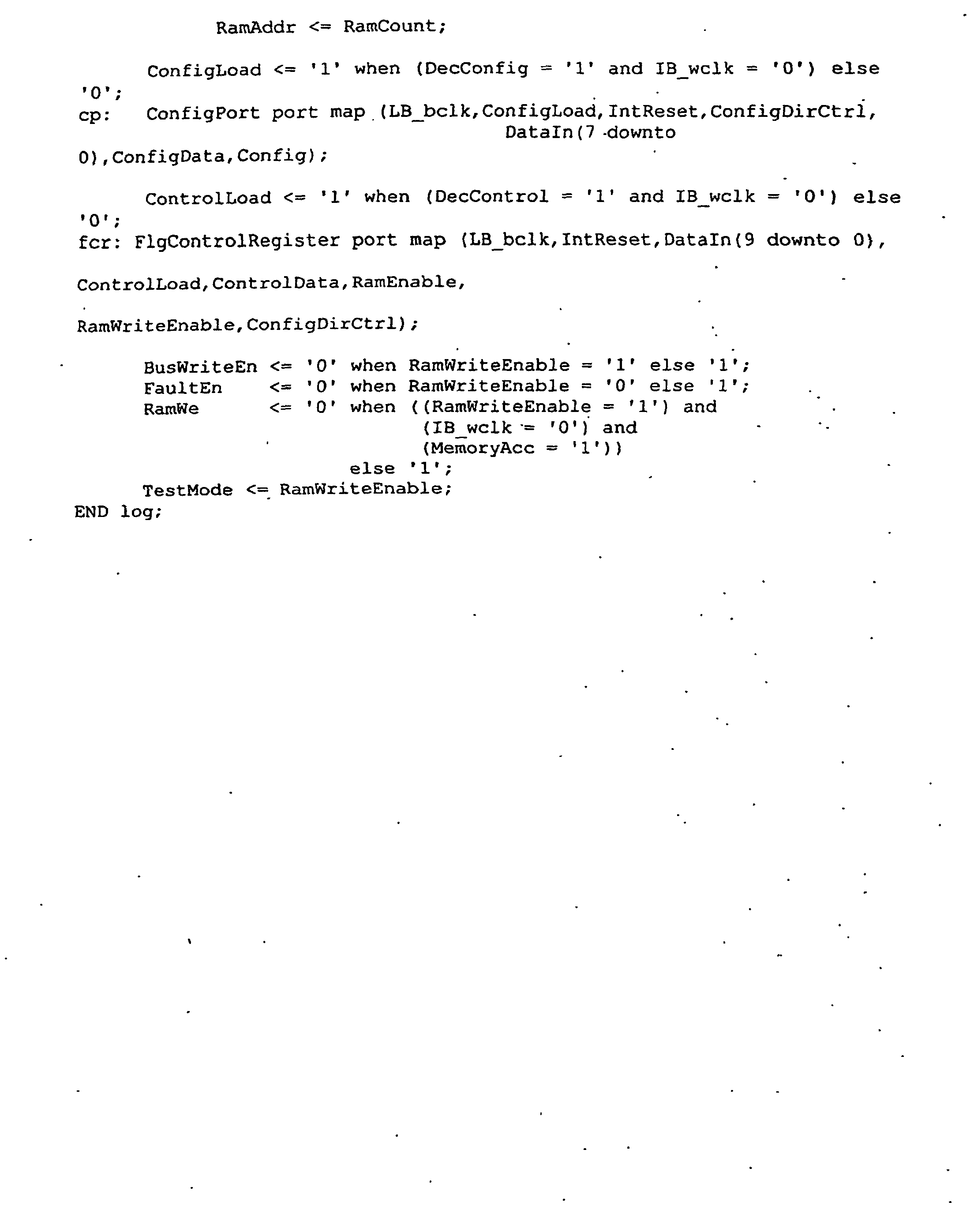

## Claims

1. A memory test system for testing a memory device (1) comprising a plurality of memory cells, the cell being the smallest addressable unit stored in the bit map, the memory test system configured with a testing means (2) for executing each test in a sequence of test patterns, a means for obtaining data on defects discovered during the test and a means for modifying the test sequence according to said data using an optimisation function, **characterised in that**
the means for obtaining defect data comprises:
a means (4) for obtaining fault bit maps for each test, test segment or test group in the sequence, where the fault bit map comprises information about defects and addresses of defective cells;
a means (6) for accumulating the fault bit map data during the test;
a means (7) for correlating each fault bit map using analysis hardware or software for determining performance data-of each test or test segment or test group at an individual cell level, and **in that**
the means for modifying the test sequence comprises an automatic optimisation means (8) for determining a modified test pattern sequence in response to the performance data in order to maximise the performance of the test, where the performance is defined by a test sequence coverage and the time of the test.

2. A memory test system according to claim 1, wherein the automatic optimisation means (8) uses the performance data of each test or test segment or test group to reduce the test time by modifying or causing to be modified the test pattern sequence of the memory tester.

3. A memory test system according to claim 1, wherein the automated optimisation means (8) uses the performance data of each test or test segment or test group to maximise the coverage as a function of time by modifying or causing to be modified the test pattern sequence of the memory tester.

4. A memory test system according to any one of claims 1 to 3, further comprising a compression means (5) for compressing the fault bit map data before accumulating.

5. A memory test system according to any one of claims 1 to 4, wherein the correlation means (7) uses the performance data of each test or test segment or test group to determine the cause of faults identified by particular tests at a geometric, type, process or electrical level.

6. A memory test system according to any one of claims 1 to 5, wherein the fault bit map data is transmitted from the testing means (2) via a storing means (3) being either a shift register, or a content addressable register, or a first-in-first-out register (FIFO), or a first-in-last-out, register (FILO) or a random access memory (RAM), the storing means (3) containing a list of address fail data, the data bit and an identidication of the device under test (DUT) with the failure.

7. A plurality of memory test systems according to claim 1 connected directly or indirectly such that the said performance data or individual cell fail bit maps are applied with a cross-correlating function for the purpose of identifying differences in the performance of test systems, or of different tests or of different test conditions or of different timing sets.

8. A method of operation of a test sequence optimisation means for optimising a sequence of test patterns executed by a test system for testing a memory device, including obtaining data on defects discovered by a plurality of tests in a sequence; and modifying the sequence to reduce the test time, **characterised in that**
a new fault bit map of the memory device is created after each test, test segment or test group;
changes or differences in those bitmaps are correlated automatically; and
the test sequence is modified based on these correlation, by selecting a first test pattern having a maximal defect coverage within a given period or a minimal time required for a given defect coverage and
adding sequentially the test pattern having the lowest coverage redundancy with respect to the selected test pattern.

9. The method of operation according to claim 8, wherein the fault bit maps are correlated to identify the particular test pattern which found each fault in a memory cell.

10. A method of operation according to claim 8 or 9, wherein the method further includes the steps of creating reduced test durations by dividing each test duration by the number of defect groups covered by each added test;
sorting the test pattern sequences in groups with the same bit amount to compose test vectors with increasing number of tests;
scanning through the vectors only once and building a result vector;
checking redundancy and removing tests with the longest time using the heuristic algorithm to decrease redundancy,
copying results to a parameter vector by creating a special array, where every cell contains either 0, if the test has not been included, or the percentage of defects covered after including this test and all previous tests.

## Patentansprüche

1. Speicherprüfsystem zum Prüfen einer Speichereinrichtung (1) mit einer Vielzahl von Speicherzellen, wobei die Zelle die kleinste adressierbare im Bitmuster gespeicherte Einheit darstellt, wobei das Speicherprüfsystem eine Prüfeinrichtung (2) zur Ausführung jeder Prüfung in einer Folge von Prüfmustern, eine Einrichtung zum Erhalten von Daten über während der Prüfung entdeckte Fehler und eine Einrichtung zum Modifizieren der Prüffolge entsprechend den Daten unter Verwendung einer Optimierungsfunktion umfasst, **dadurch gekennzeichnet, dass** die Einrichtung zum Erhalten von Fehlerdaten umfasst:
eine Einrichtung (4) zum Erhalten von Fehlerbitmustern für jede Prüfung, jedes Prüfungssegment oder jede Prüfgruppe in der Folge, wobei das Fehlerbitmuster Informationen über Fehler und Adressen fehlerhafter Zellen umfasst,
eine Einrichtung (6) zum Akkumulieren der Fehlerbitmusterdaten während der Prüfung,
eine Einrichtung (7) zum Korrelieren jedes Fehlerbitmusters unter Verwendung einer Analyse-Hardware oder -Software zur Bestimmung von Leistungsdaten jeder Prüfung oder jedes Prüfungssegments oder jeder Prüfgruppe auf einer individuellen Zellenstufe, wobei die Leistung durch eine Prüffolgenabdeckung und die Zeit der Prüfung definiert ist, und dass
die Einrichtung zum Modifizieren der Prüffolge eine automatische Optimierungseinrichtung (8) zur Bestimmung einer modifizierten Prüfmusterfolge im Ansprechen auf die Leistungsdaten zum Maximieren der Leistungsfähigkeit der Prüfung umfasst.

2. Speicherprüfsystem nach Anspruch 1, wobei die automatische Optimierungseinrichtung (8) die Leistungsdaten jeder Prüfung oder jedes Prüfungssegments oder jeder Prüfgruppe zum Verringern der Prüfungszeit durch Modifizieren der Prüfmusterfolge der Speicherprüfeinrichtung oder Bewirken verwendet, dass die Prüfmusterfolge der Speicherprüfeinrichtung modifiziert wird.

3. Speicherprüfsystem nach Anspruch 1, wobei die automatische Optimierungseinrichtung (8) die Leistungsdaten jeder Prüfung oder jedes Prüfungssegments oder jeder Prüfgruppe zum Maximieren der Abdeckung als Funktion der Zeit durch Modifizieren der Prüfmusterfolge der Speicherprüfeinrichtung oder Bewirken verwendet, dass die Prüfmusterfolge der Speicherprüfeinrichtung modifiziert wird.

4. Speicherprüfsystem nach einem der Ansprüche 1 bis 3, ferner mit einer Komprimierungseinrichtung (5) zum Komprimieren der Fehlerbitmusterdaten vor der Akkumulierung.

5. Speicherprüfsystem nach einem der Ansprüche 1 bis 4, wobei die Korrelierungseinrichtung (7) die Leistungsdaten jeder Prüfung oder jedes Prüfsegments oder jeder Prüfgruppe zur Bestimmung der Ursache von durch bestimmte Prüfungen identifizierten Fehlern auf geometrischer, Typ-, Prozess- oder elektrischer Stufe verwendet.

6. Speicherprüfsystem nach einem der Ansprüche 1 bis 5, wobei die Fehlerbitmusterdaten von der Prüfeinrichtung (2) über eine Speichereinheit (3) übertragen werden, die entweder ein Schieberegister oder ein Register mit adressierbarem Inhalt oder ein FIFO (first-in-first-out)-Register oder ein FILO (first-in-last-out)-Register oder ein Speicher mit wahlfreiem Zugriff (RAM) ist, wobei die Speichereinrichtung (3) eine Liste von Adressfehlerdaten, das Datenbit und eine Identifizierung der geprüften Einrichtung (DUT) mit dem Fehler enthält.

7. Vielzahl von Speicherprüfsystemen nach Anspruch 1, die direkt oder indirekt verbunden sind, so dass die Leistungsdaten oder individuellen Zellenfehlerbitmuster mit einer Kreuzkorrelationsfunktion zum Zweck der Identifizierung von Unterschieden in der Leistung von Prüfsystemen oder verschiedener Prüfungen oder verschiedener Prüfbedingungen oder verschiedener Zeiteinstellungen beaufschlagt werden.

8. Verfahren zum Betreiben einer Prüffolgenoptimierungseinrichtung zum Optimieren einer Folge von Prüfmustern, die durch ein Prüfsystem zum Prüfen einer Speichereinrichtung ausgeführt werden, mit dem Erhalten von Daten über durch eine Vielzahl von Prüfungen in einer Folge entdeckte Fehler und Modifizieren der Folge zum Verringern der Prüfzeit, **dadurch gekennzeichnet, dass**
ein neues Fehlerbitmuster der Speichereinrichtung nach jeder Prüfung, jedem Prüfsegment oder jeder Prüfgruppe erzeugt wird,
Änderungen oder Unterschiede in diesen Bitmustern automatisch korreliert werden, und
die Prüffolge beruhend auf dieser Korrelation modifiziert wird durch
Auswählen eines ersten Prüfmusters mit einer maximalen Fehlerabdeckung innerhalb eines gegebenen Zeitabschnitts oder einer minimalen Zeit, die für eine gegebene Fehlerabdeckung erforderlich ist, und
sequenzielles Hinzufügen des Prüfmusters mit der geringsten Abdeckungsredundanz bezüglich des ausgewählten Prüfmusters.

9. Verfahren zum Betreiben nach Anspruch 8, wobei die Fehlerbitmuster zum Identifizieren des bestimmten Prüfmusters korreliert werden, das jeden Fehler in einer Speicherzelle gefunden hat.

10. Verfahren zum Betreiben nach Anspruch 8 oder 9, wobei das Verfahren ferner die Schritte der Erzeugung verkürzter Prüfdauern durch Teilen jeder Prüfdauer durch die Anzahl von durch jede hinzugefügte Prüfung abgedeckten Fehlergruppen,
der Sortierung der Prüfmusterfolgen in Gruppen mit der gleichen Bitmenge zum Zusammensetzen von Prüfvektoren mit steigender Anzahl von Prüfungen,
der Abtastung der Vektoren lediglich einmal und der Bildung eines Ergebnisvektors,
der Überprüfung einer Redundanz und der Beseitigung der Prüfungen mit der längsten Zeit unter Verwendung des heuristischen Algorithmus zur Verringerung von Redundanz, und
des Kopierens von Ergebnissen in einen Parametervektor durch Erzeugung eines bestimmten Arrays enthält, wobei jede Zelle entweder Null enthält, wenn die Prüfung nicht aufgenommen wurde, oder den Prozentsatz von Fehlern enthält, die nach der Aufnahme dieser Prüfung und aller vorhergehenden Prüfungen abgedeckt sind.

## Revendications

1. Système de test de mémoire pour tester un dispositif de mémoire (1) qui comprend une pluralité de cellules de mémoire, la cellule étant l'unité adressable la plus petite qui est stockée dans la carte de bits ou bitmap, le système de test de mémoire étant configuré de manière à comporter un moyen de test (2) pour exécuter chaque test selon une séquence de motifs de test, un moyen pour obtenir des données concernant des défauts découverts pendant le test et un moyen pour modifier la séquence de motifs de test conformément auxdites données en utilisant une fonction d'optimisation,
**caractérisé en ce que** :
le moyen pour obtenir des données de défaut comprend :
un moyen (4) pour obtenir des cartes de bit ou bitmaps de défaillances pour chaque test, pour chaque segment de test ou pour chaque groupe de tests dans la séquence, où la carte de bits ou bitmap de défaillances comprend une information concernant des défauts et des adresses de cellules défectueuses ;
un moyen (6) pour accumuler les données de carte de bit ou bitmap de défaillances pendant le test ;
un moyen (7) pour corréler chaque carte de bits ou bitmap de défaillances en utilisant un composant matériel ou un logiciel d'analyse pour déterminer des données de performance de chaque test ou de chaque segment de test ou de chaque groupe de tests à un niveau de cellule individuelle; et **en ce que**
le moyen pour modifier la séquence de motifs de test comprend un moyen d'optimisation automatique (8) pour déterminer une séquence de motifs de test modifiée en réponse aux données de performance afin de maximiser la performance du test, où la performance est définie par une couverture de séquence de motifs de test et par le temps du test.

2. Système de test de mémoire selon la revendication 1, dans lequel le moyen d'optimisation automatique (8) utilise les données de performance de chaque test ou de chaque segment de test ou de chaque groupe de tests afin de réduire le temps de test en modifiant ou en provoquant la modification de la séquence de motifs de test du testeur de mémoire.

3. Système de test de mémoire selon la revendication 1, dans lequel le moyen d'optimisation automatique (8) utilise les données de performance de chaque test ou de chaque segment de test ou de chaque groupe de tests afin de maximiser la couverture en fonction du temps en modifiant ou en provoquant la modification de la séquence de motifs de test du testeur de mémoire.

4. Système de test de mémoire selon l'une quelconque des revendications 1 à 3, comprenant en outre un moyen de compression (5) pour comprimer les données de carte de bit ou bitmap de défaillances avant accumulation.

5. Système de test de mémoire selon l'une quelconque des revendications 1 à 4, dans lequel le moyen de corrélation (7) utilise les données de performance de chaque test ou de chaque segment de test ou de chaque groupe de tests pour déterminer la cause de défaillances qui sont identifiées au moyen de tests particuliers à un niveau de géométrie, de type, de processus ou électrique.

6. Système de test de mémoire selon l'une quelconque des revendications 1 à 5, dans lequel les données de carte de bit ou bitmap de défaillances sont transmises depuis le moyen de test (2) via un moyen de stockage (3) qui est soit un registre à décalage. soit un registre adressable en termes de contenu, soit un registre premier entré, premier sorti (FIFO), soit un registre premier entré dernier sorti (FILO), soit une mémoire vive (RAM), le moyen de stockage (3) contenant une liste de données de défaillance d'adresse, le bit de données et une identification du dispositif sous test (DUT) avec la défaillance.

7. Pluralité de systèmes de test de mémoire selon la revendication 1. connectés directement ou indirectement de telle sorte que lesdites données de performance ou lesdites cartes de bit ou bitmaps de défaillances de cellule individuelle reçoivent en application une fonction de corrélation croisée dans le but d'identifier des différences au niveau de la performance de systèmes de test ou de tests différents ou de conditions de test différentes ou d'établissements de cadencement différents.

8. Procédé de fonctionnement d'un moyen d'optimisation de séquence de motifs de test pour optimiser une séquence de motifs de test exécutée par un système de test pour tester un dispositif de mémoire, incluant l'obtention de données concernant des défauts qui sont découverts au moyen d'une pluralité de tests selon une séquence, et la modification de la séquence afin de réduire le temps de test, **caractérisé en ce que** :
une nouvelle carte de bits ou bitmap de défaillances du dispositif de mémoire est créée après chaque test, chaque segment de test ou chaque groupe de tests ;
des modifications ou des différences dans ces cartes de bit ou bitmaps sont corrélées de manière automatique ; et
la séquence de motifs de test est modifiée sur la base de ces corrélations en :
sélectionnant un premier motif de test présentant une couverture de défaut maximum dans une période donnée ou un temps minimum requis pour une couverture de défaut donnée ; et en
additionnant de façon séquentielle le motif de test présentant ta redondance de couverture la plus basse en relation avec le motif de test sélectionné.

9. Procédé de fonctionnement selon la revendication 8, dans lequel les cartes de bits ou bitmaps de défaillances sont corrélées afin d'identifier le motif de test particulier qui a trouvé chaque défaillance dans une cellule de mémoire.

10. Procédé de fonctionnement selon la revendication 8 ou 9. dans lequel le procédé inclut en outre les étapes de :
création de durées de test réduites en divisant chaque durée de test par le nombre de groupes de défauts couverts par chaque test additionné ;
tri des séquences de motifs de test selon des groupes moyennant la même quantité de bits pour composer des vecteurs de test selon des numéros croissants des tests ;
balayage sur les vecteurs seulement une fois et construction d'un vecteur de résultat ;
vérification de redondance et enlèvement des tests présentant le temps le plus long en utilisant l'algorithme heuristique pour diminuer la redondance ;
copie des résultats sur un vecteur de paramètre en créant un réseau spécial où chaque cellule contient soit 0 si le test n'a pas été inclus, soit le pourcentage de défauts couverts après inclusion de ce test et de tous les tests précédents.
